# EUROPEAN PATENT SPECIFICATION

(11) **EP 3 935 737 B1**
(45) Date of publication and mention of the grant of the patent: **29.05.2024**
(21) Application number: 20709582.9
(22) Date of filing: 09.03.2020
(51) Int. Cl.: H03K 17/06, H01L 29/40, H01L 29/66

(54) **TRANSISTOR ARRANGEMENT AND ELECTRONIC CIRCUIT WITH A TRANSISTOR ARRANGEMENT**
VERFAHREN ZUM BETRIEB EINER SUPERJUNCTION-TRANSISTORVORRICHTUNG
PROCÉDÉ DE FONCTIONNEMENT D'UN DISPOSITIF DE TRANSISTOR À SUPERJONCTION

(30) Priority: 08.03.2019 EP 19161485; 20.01.2020 WO PCT/EP2020/051245
(43) Date of publication of application: 12.01.2022
(73) Proprietor: Infineon Technologies Austria AG, 9500 Villach (AT)
(72) Inventor: WEBER, Hans, 83457 Bayerisch Gmain (DE); FISCHER, Björn, 81547 München (DE); HIRLER, Franz, 84424 Isen (DE); KUTSCHAK, Matteo-Alessandro, 9072 Ludmannsdorf (AT); RIEGLER, Andreas, 9241 Lichtpold (AT)
(74) Representative: Westphal, Mussgnug & Partner, Patentanwälte mbB
(86) International application number: PCT/EP2020/056196
(87) International publication number: WO 2020/182721

(56) References cited:
- US-A1- 2014 063 882
- US-A1- 2014 084 295
- US-A1- 2015 179 633
- US-A1- 2016 006 353

## Description

This disclosure relates in general to a transistor arrangement, in particular a transistor arrangement with a superjunction transistor device and to an electronic circuit with a transistor arrangement.

A superjunction transistor device, which may also be referred to as superjunction MOSFET, may receive across a load path a voltage with a first polarity or a voltage with a second polarity opposite the first polarity. When the load path voltage has the first polarity the MOSFET can be operated in an on-state (switched on state) or an off state (switched off state) by applying a suitable drive voltage to a drive input. When the load path voltage has the second polarity the MOSFET is in a conducting state independent off the drive voltage received at the drive input.

When the load path voltage has the second polarity the MOSFET can be operated in the on-state or the off-state. In the off-state, an internal body diode is forward biased. The operating state in which the MOSFET is in the off-state and the load path voltage has the second polarity may also be referred to as diode state of the MOSFET.

When the MOSFET operates in the diode state, there is a charge carrier plasma including both n-type charge carriers (electrons) and p-type charge carriers (holes) in a drift region of the MOSFET. When the polarity of the load path voltage changes such that the body diode is reverse biased these charge carriers have to be removed before the MOSFET blocks. Further, when the charge carriers forming the plasma have been removed, so that the MOSFET blocks, and as the load path voltage increases a depletion region (space charge regions) is formed in the drift region. Forming this depletion region is associated with a removal of free charge carriers in the drift region and the body region and, therefore, a storing of a fixed net charge in the drift and body region. In a superjunction device, the depletion region also expands in a compensation region that adjoins the drift region and has a doping type complementary to a doping type of the drift region.

Removing the charge carriers of the charge carrier plasma from the transistor device and charging the drift, body and the compensation regions is associated with a charging current, which may also be referred to as reverse recovery current. This current is associated with losses. Basically, the losses associated with changing the operating state of the transistor device from the diode state to the blocking state are given by the integral of the reverse recovery current multiplied with the voltage across a current path through which the charging current flows These losses may occur in the transistor device itself, but may also occur in devices connected to the transistor device. For example, the transistor device may be used as one of two switches in a half-bridge and the change of the operating state of the transistor device from the diode state to the blocking state may be caused by a change of the operating state of the other one of the two switches. In this case, the reverse recovery current may not only flow through the transistor device itself, but may also flow through the other one of the switches, where it may cause losses. The overall losses associated with changing the operating state of the transistor device may be referred to as commutation losses.

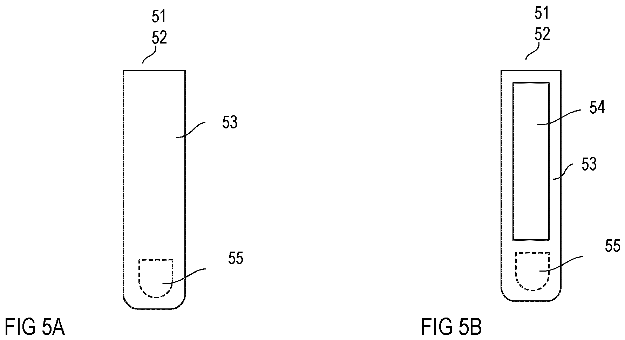

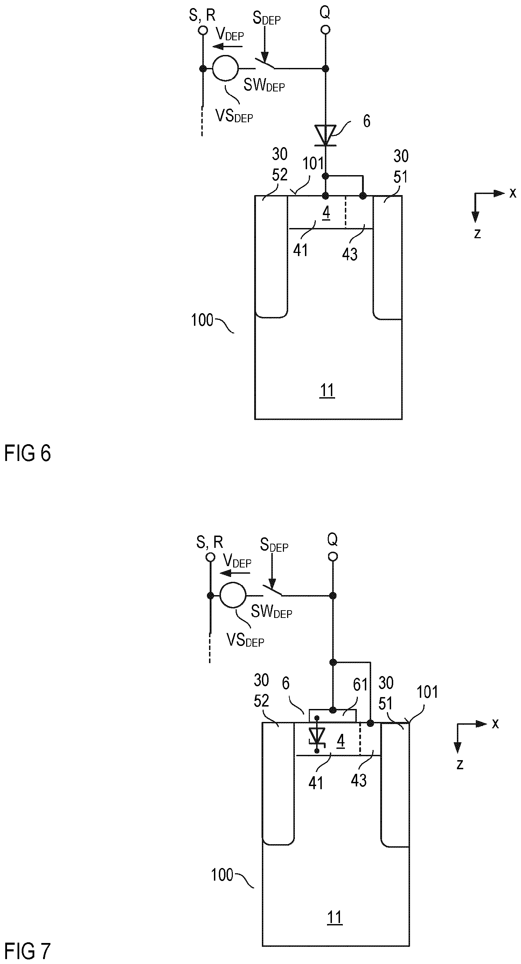

US 2016/006353 A1 discloses a transistor device with a field electrode (Figure 5) and a superjunction transistor device (Figure 6). Each of these transistor devices includes, in a semiconductor body, a drift region of a first doping type, a body region of a second doping type complementary to the first doping type, and a source region of the first doping type. Furthermore, each of the transistor devices includes a gate electrode that is coupled to a gate node, is dielectrically insulated from the semiconductor body, and is arranged in a gate trench extending into the semiconductor body. In the transistor device with the field electrode, the field electrode is located in the drift region and is dielectrically insulated from the drift region. The superjunction transistor device includes a compensation region of the second doping type, wherein the compensation region is located in the drift region and adjoins the drift region. Furthermore, each of the field electrode and the compensation region can be connected to a biasing source.

US 2014/084295 A1 discloses transistor device that includes, in a semiconductor body, a drift region of a first doping type, a body region of a second doping type complementary to the first doping type, and a source region of the first doping type. A gate electrode is coupled to a gate node, is dielectrically insulated from the semiconductor body, and is arranged in a gate trench extending into the semiconductor body. A field electrode is coupled to a source node via a diode, is dielectrically insulated from the semiconductor body, and is arranged in a trench that is spaced apart from the gate trench.

US 2015/179633 A1 discloses transistor devices that includes, in a semiconductor body, a drift region of a first doping type, a body region of a second doping type complementary to the first doping type, and a source region of the first doping type. A gate electrode is coupled to a gate node, is dielectrically insulated from the semiconductor body, and is arranged in a gate trench extending into the semiconductor body. The transistor device further includes a drift control region that is dielectrically insulated from the drift region by a dielectric layer and that is connected to a biasing source via an electronic switch.

There is a need for reducing losses that are associated with a transition of a superjunction transistor device from a diode state to a blocking state.

One example relates to a transistor arrangement. The transistor arrangement includes, in a semiconductor body, a drift region of a first doping type, a compensation region of a second doping type complementary to the first doping type, a body region of the second doping type, and a source region of the first doping type, The transistor arrangement further includes: a gate electrode, wherein the gate electrode is coupled to a gate node, is dielectrically insulated from the semiconductor body and is arranged in a gate trench that extends into the semiconductor body and adjoins the compensation region; a first field electrode, wherein the first field electrode is dielectrically insulated from the semiconductor body and is arranged in a first isolation trench that extends into the semiconductor body, wherein the first isolation trench is spaced apart from the gate trench and adjoins the compensation region; and a bias node different from the gate node and connected to the first field electrode.

Examples are explained below with reference to the drawings. The drawings serve to illustrate certain principles, so that only aspects necessary for understanding these principles are illustrated. The drawings are not to scale. In the drawings the same reference characters denote like features.
Figure 1 illustrates one example of a transistor arrangement that includes a superjunction transistor device integrated in a semiconductor body, a bias region integrated in the semiconductor body, a bias voltage source, and an optional bias switch;
Figures 2A and 2B show one example of a transistor arrangement of the type shown in Figure 1 in greater detail;
Figure 3 shows a modification of the transistor arrangement shown in Figures 2A and 2B;
Figures 4A and 4B show further modifications of the transistor arrangement shown in Figures 2A and 2B;
Figures 5A and 5B illustrate examples of isolation trenches shown in Figures 4A and 4B;
Figure 6 illustrates one example of a transistor arrangement in which a diode is connected between the bias voltage source and the bias region;
Figure 7 illustrates one example in which the diode illustrated in Figure 6 is implemented as a Schottky diode;
Figures 8 to 13C illustrate various different implementations of the bias region and the bias switch;
Figure 14 illustrates one example of a transistor arrangement that is based on the transistor arrangement shown in Figure 1 and includes a bias capacitor;
Figures 15A and 15B show one example of a transistor arrangement of the type shown in Figure 14 in greater detail;
Figure 16 shows another example of a transistor arrangement of the type shown in Figure 14 in greater detail;
Figure 17 shows a modification of the transistor arrangement shown in Figure 14;
Figure 18 illustrates one example of how the transistor arrangement shown in Figure 17 may be implemented;
Figure 19 shows a vertical cross sectional view of a conventional superjunction transistor device;
Figure 20 illustrates a gate-drain capacitance and a drain-source capacitance of the conventional transistor device shown in Figure 19 dependent on a drain-source voltage;
Figure 21 illustrates one example of a superjunction transistor device with an improved gate-drain capacitance profile;
Figure 22 illustrates a gate-drain capacitance and a drain-source capacitance of the transistor device shown in Figure 21 dependent on a drain-source voltage;
Figure 23 illustrates a modification of the superjunction transistor device shown in Figure 21;
Figure 24 illustrates a modification of the superjunction transistor device shown in Figure 23;
Figure 25 illustrates one example of an electronic circuit in which the transistor arrangement of the type illustrated in Figure 1 may be used;
Figures 26 and 27 show signal waveforms that illustrate different examples of a method for operating the electronic circuit shown in Figure 25;
Figure 28 illustrates an example of a power converter with a buck topology, wherein the power converter includes a half-bridge with a low-side switch implemented as a transistor arrangement with a superjunction transistor device;
Figure 29 illustrates an example of a power converter with a totem-pole topology, wherein the power converter includes a half-bridge with a low-side switch implemented as a transistor arrangement with a superjunction transistor device;
Figure 30 illustrates one example of a power converter with a B6-topology, wherein the power converter includes three half-bridges each including a low-side switch implemented as a transistor arrangement with a superjunction transistor device;
Figure 31 illustrates a modification of the power converter shown in Figure 28; and
Figure 32 illustrates a flying capacitor converter with several switches each implemented as a transistor arrangement with a superjunction transistor device.

In the following detailed description, reference is made to the accompanying drawings. The drawings form a part of the description and for the purpose of illustration show examples of how the invention may be used and implemented. It is to be understood that the features of the various embodiments described herein may be combined with each other, unless specifically noted otherwise.

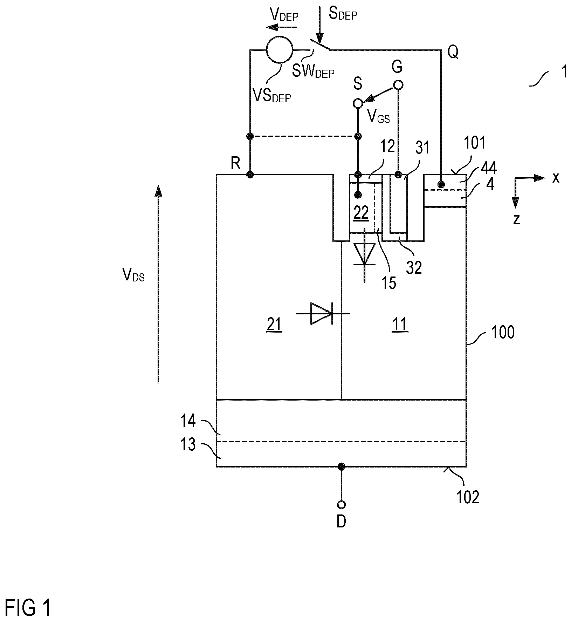

Figure 1 schematically illustrates a transistor arrangement 1 with a transistor device. More specifically, Figure 1 shows a vertical cross sectional view of a semiconductor body 100 in which the transistor device is integrated and circuit symbols of further electronic devices of the transistor arrangement. It should be noted that Figure 1 schematically illustrates some features of the transistor device in order to explain its functionality. These features may be arranged in the semiconductor body 100 in various ways. Thus, Figure 1 rather illustrates which features the transistor device includes, than a specific implementation. Examples for implementing the transistor device are explained in detail herein further below.

Referring to Figure 1, the transistor device includes a drift region 11 of a first doping type (first conductivity type), a source region 12 of the first doping type and a body region 22 of a second doping type (second conductivity type) complementary to the first doping type. One of the first doping type and the second doping type is an n-type and the other one of the first doping type and the second doping type is a p-type. The body region 22 separates the source region 12 from the drift region 11. Further, the body region 22 adjoins the drift region 11 so that a pn-junction (represented by a diode in Figure 1) is formed between the body region 22 and the drift region 11. This pn-junction is referred to as first pn-junction in the following. Each of the source region 12 and the body region 22 is connected to a source node S of the transistor device.

According to one example, each of the source region 12 and the body region 22 is connected to the source node S such that an ohmic contact is formed between the source node S and the respective device region 12, 22. The source node S may be formed by a source metallization (not illustrated) so that the ohmic contact between source and body regions 12, 22 and the source node S may include an ohmic contact between the source and body regions 12, 22 and the source metallization.

A gate electrode 31 is arranged adjacent the body region 22 and is dielectrically insulated from the body region 22 by a gate dielectric 32. The gate electrode 32 is connected to a gate node G and serves to control a conducting channel in the body region 22 along the gate dielectric 32 between the source region 12 and the drift region 11.

The transistor device further includes a drain region 13 of the first doping type. The drain region 13 is connected to a drain node D, is spaced apart from the body region 22 in a current flow direction of the transistor device and is separated from the body region 22 by the drift region 11. Optionally, a buffer region 14 of the first doping type is arranged between the drain region 13 and the drift region 11. The buffer region 14 has a lower doping concentration than the drift region 11, for example.

The transistor device is implemented as a superjunction transistor device and further includes a compensation region 21 of the second doping type. The compensation region 21 adjoins the drift region 11 and may or may not adjoin the body region 22. More detailed examples with regard to the arrangement of the compensation region 21 relative to the body region 22 are explained herein further below. As the doping type of the compensation region 21 is complementary to the doping type of the drift region 11 a further pn-junction (represented by a diode in Figure 1) is formed between the compensation region 21 and the drift region 11. This pn-junction is referred to as second pn-junction in the following. Referring to Figure 1, the drift region 11 and the compensation region 21 may be implemented in such a way that the second pn-junction essentially extends in the current flow direction. Optionally, as illustrated in dashed lines in Figure 1, the compensation region 21 is connected to the source node S.

The transistor device further includes a bias region 4. The bias region 4 is a doped region of either the first doping type or the second doping and is coupled to the drift region 11. "Coupling the bias region 4 to the drift region 11" includes electrically coupling the bias region 4 to the drift region 11 in any possible way and may include directly coupling the bias region 4 to the drift region 11 such that the bias region 4 adjoins the drift region 11 or may include indirectly coupling the bias region 4 to the drift region 11. "Indirectly coupling the bias region 4 to the drift region 11" may include coupling the bias region 4 to the drift region 11 via an electronic switch such as a transistor, for example.

Just for the purpose of illustration, in the transistor device shown in Figure 1, the current flow direction of the transistor device corresponds to a vertical direction z of the semiconductor body 100. The "vertical direction z" of the semiconductor body 100 is a direction perpendicular to a first surface 101 and a second surface 102, wherein the second surface 102 is spaced apart from the first surface 102. In addition to the first and second surfaces 101, 102, which may also be referred to as front and rear surfaces, the semiconductor body 100 includes side surfaces (edge surfaces) that each extend from the first surface 101 to the second surface 102. These side surfaces, however, are out of view in the section of the semiconductor body 100 illustrated in Figure 1.

A transistor device of the type shown in Figure 1 in which the current flow direction corresponds to the vertical direction of the semiconductor body 100 may be referred to as vertical transistor device. Implementing the transistor device as a vertical transistor device, however, is only an example. The principles explained hereinbefore and hereinabove also apply to a lateral transistor device, which is a transistor device in which the current flow direction corresponds to a lateral direction of the semiconductor body 100. The "lateral direction" is a direction parallel to the first and second surfaces 101, 102 of the semiconductor body.

According to one example, the semiconductor body 100 includes a monocrystalline semiconductor material. Examples of the monocrystalline semiconductor material include, but are not restricted to, silicon (Si), silicon carbide (SiC), gallium arsenide (GaAs), gallium nitride (GaN), or the like.

According to one example, the semiconductor body 100 includes monocrystalline silicon and the individual active device regions are implemented such that a respective doping concentration is in a range as outlined in the following:
drift region 11: between 1E15 cm⁻³ and 1E17 cm⁻³;
compensation region 21: between 1E15 cm⁻³ and 1E17 cm⁻³;
body region 22: between 1E17 cm⁻³ and 1E18 cm⁻³;
source region 12: between 1E18 cm⁻³ and 1E21 cm⁻³;
drain region 13: between 1E18 cm⁻³ and 1E21 cm⁻³;
optional buffer region 14: between 5E14 cm⁻³ and 1E17 cm⁻³.

Referring to the above, the bias region 4 may be implemented as a doped region of (1) the first doping type, or (2) the second doping type. In the first case (1), the doping concentration of the bias region 4 is in a range of between 1E16 cm⁻³ and 1E21 cm⁻³, for example. In the second case (2), the doping concentration is in a range of between 1E15 cm⁻³ and 1E18 cm⁻³, for example. In the second case, the bias region 4 may be formed by the same process that forms the body region 22, so that the doping concentrations of the body region 22 and the bias region 4 may essentially be the same.

Referring to the above, an ohmic contact may be formed between the body region 22 and the source node S. In this case, the body region 22 may include a contact region (not shown) of the second doping type, wherein a doping concentration of the contact region is high enough, to achieve an ohmic contact between the source node S (the source metallization) and the body region 22. The doping concentration is between 1E18 cm⁻³ and 1E21 cm⁻³, for example.

Referring to Figure 1, the bias region 4 is connected to a bias node Q, which is explained in detail herein further below. According to one example, an ohmic contact is formed between the bias region 4 and the bias node Q. In this case, the bias region 4 may include a contact region 44 (illustrated in dashed lines) that is of the same doping type as the bias region 4 and has a doping concentration that is high enough to achieve an ohmic contact between a bias node Q and the body region 22. The doping concentration of the contact region 44 is between 1E18 cm⁻³ and 1E21 cm⁻³, for example. Such contact region 44 may be included in each of the examples explained below, although the contact region 44 is not illustrated in the further examples. The bias node Q may be formed by a metallization (not shown) separate from the source metallization.

The doping type of the source, drift and drain regions 12, 11, 13 defines the conductivity type of the superjunction transistor device. These device regions 12, 11, 13 are regions of the first doping type so that the superjunction transistor device is a transistor device of the first conductivity type. More specifically, the superjunction transistor device is an n-type transistor device when the semiconductor regions of the first doping type are n-type semiconductor regions and the semiconductor regions of the second doping type are p-type semiconductor regions, and the superjunction transistor device is a p-type transistor device when the semiconductor regions of the first doping type are p-type semiconductor regions and the semiconductor regions of the second doping type are n-type semiconductor regions. Further, the transistor device can be implemented as an enhancement (normally-off) device or as a depletion (normally-on) device. In an enhancement device, the body regions 22 adjoin the gate dielectric 32. In a depletion device, there is a channel region 15 (illustrated in dashed lines) of the first doping type that extends from the source region 12 to the drift region 11 along the gate dielectric 32 and is arranged between the gate dielectric 32 and the body region 22.

In the transistor device shown in Figure 1, a load path is formed between the drain node D and the source node S. A voltage V_{DS} between these nodes is referred to as load path voltage or drain-source voltage in the following. A drive input is formed by the gate node G and the source node S, for example. A voltage V_{GS} received at the drive input is referred to as drive voltage or gate-source voltage in the following. Dependent on a voltage level of the drive voltage V_{GS} a conducting channel is formed along the gate dielectric 32 in the body region 22 between the drift region 11 and the source region 12.

In a n-type enhancement transistor device, for example, a conducting channel is generated along the gate dielectric 32 when the voltage level of the drive voltage V_{GS} is higher than a threshold voltage of the transistor device. The threshold voltage is dependent on the conductivity type of the transistor device and dependent on whether the transistor device is an enhancement device or a depletion device. This is commonly known, so that no further explanation is required in this regard.

The superjunction transistor device shown in Figure 1 can be operated in four different operating states:
(a) In a first operating state (which is also referred to as forward conducting state in the following), the gate electrode 32 is controlled such that there is a conducting channel in the body region 22 along the gate dielectric 32 between the source region 12 and the drift region 11. Further, in the first operating state, a voltage applied between the drain node D and the source node S has a first polarity such that the first pn-junction between the drift region 11 and the body region 22 is reverse biased. In an n-type transistor device, for example, the first pn-junction between the drift region 11 and the body region 22 is reverse biased when the load path voltage V_{DS} is a positive voltage. In this operating state, a unipolar current can flow between the drain node D and the source node S via the drain region 13, the optional buffer region 14, the drift region 11, the channel in the body region 22 along the gate dielectric 32, and the source region 12. In an n-type transistor device, for example, the unipolar current includes electrons as charge carriers.
(b) In a second operating state (which is also referred to as reverse conducting state in the following), the gate-source voltage V_{GS} is such that there is a conducting channel in the body region 22 along the gate dielectric 32, which is similar to the first operating state explained above. In the second operating state, however, the drain-source voltage V_{DS} has a second polarity that is opposite the first polarity in the first operating state , so that a current can flow between the drain node D and the source node S. In the second operating state the current flows in a direction that is opposite to the direction of the current flow in the first operating state. Basically, the current is a unipolar current and flows between the drain node D and the source node S via the drain region 13, the optional buffer region 14, the drift region 11, the channel in the body region 22 along the gate dielectric 32, and the source region 12. However, situations may occur in which a voltage across the first pn-junction between the body region 22 and the drift region 11 becomes higher than a forward voltage of this pn-junction, so that in the reverse conducting state, parallel to the conducting channel in the body region 22, a bipolar diode formed by the body region 22, the drift region 11 and the drain region 13 becomes active and a bipolar current sets in.
(c) In a third operating state, the gate-source voltage V_{GS} is such that there is no conducting channel in the body region 22 along the gate dielectric 32. Further, in the third operating state, the drain-source voltage V_{DS} has the second polarity so that the first pn-junction between the body region 22 and the drift region 11 is forward biased. This operating state is also referred to as diode state in the following.
(d) In the fourth operating state, the gate-source voltage V_{GS} is such that there is no conducting channel in the body region 22 along the gate dielectric 32. Further, in the fourth operating state, the drain-source voltage has the first polarity, that is, a polarity of the drain-source voltage V_{DS} is such that the pn-junction between the body region 22 and the drift region 11 is reverse biased. This operating state is also referred to as blocking state in the following.

In the third operating state (diode state) charge carriers of the first conductivity type are injected by the drain region 13 into the drift region 11 and charge carriers of the second conductivity type are injected by the body region 22 into the drift region 11 so that there is a charge carrier plasma including charge carriers of the first and second conductivity type primarily in the drift region 11, the compensation region 21 and the optional buffer region 14. In an n-type transistor device, the charge carriers injected by the drain region 13 are electrons and the charge carriers injected by the body region 22 are holes.

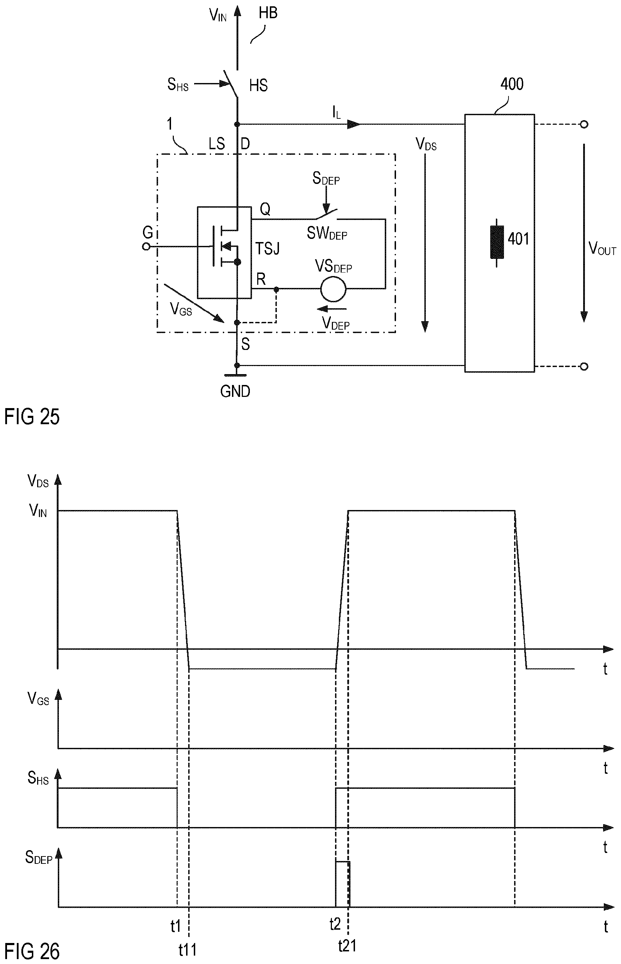

When the transistor device changes from the diode state into the (forward biased) blocking state (the fourth operating state), for example, the charge carriers forming the charge carrier plasma need to be removed from the drift region 11 before the transistor device blocks, that is, before a current through the transistor device turns to zero. Furthermore, in the blocking state, charge carriers are stored in a junction capacitance that is formed by the first pn-junction (the pn-junction between the body region 22 and the drift region 11) and the second pn-junction(the pn-junction between the drift region 11 and the compensation region 21. Switching the superjunction transistor device from the diode state to the blocking state is associated with losses, wherein these losses are essentially given by the integral of the current that removes the charge carrier plasma and charges the junction capacitance multiplied with the voltage across a current path through which the current flows. These losses may occur in the transistor device 1 itself, but may also occur in an external device such as another transistor device connected in series with the transistor device 1. The latter is explained with reference to Figure 25 herein further below.

In the transistor device 1 according to Figure 1, losses associated with changing the operating state of the transistor device from the diode state to the blocking state may be reduced by applying a bias voltage V_{DEP} between the bias region 4 and at least one of the compensation region 21 and the body region 22, wherein the bias voltage V_{DEP} is different from zero. As outlined in further detail herein below, a polarity of the bias voltage V_{DEP} is such that the pn-junction between the drift region 11 and the at least one of the compensation region 21 and the body region 22 is reverse biased, that is at least one of the second pn-junction and the first pn-junction is reverse biased. The bias voltage V_{DEP} may be provided by any kind of voltage source VS_{DEP} that is configured to provide the bias voltage V_{DEP} and is connected between the bias region 4 and the at least one of the compensation region 21 and the body region 22. This voltage source VS_{DEP} is referred to as bias voltage source in the following. A circuit node Q outside the semiconductor body 100 and connected between the voltage source providing the bias voltage V_{DEP} and the bias region 4 is referred to as bias node Q in the following.

According to one example, the bias voltage V_{DEP} is applied between the bias region 4 and only the compensation region 21. According to another example, the bias voltage V_{DEP} is applied between the bias region 4 and both the compensation region 21 and the body region 22. According to yet another example, the bias voltage V_{DEP} is applied between the bias region 4 and only the body region 22.

In Figure 1, reference character R denotes a circuit node connected to the compensation region 21. This circuit node R is referred to as further bias node in the following. In the example illustrated in Figure 1, the bias voltage V_{DEP} is applied between bias node Q (that is connected to the bias region 4) and the further bias node R (that is connected to the compensation region 21). The source node S and the further bias node R may be connected (as illustrated in dashed lines in Figure 1) or may even be formed by the same circuit node.

Optionally, the bias voltage V_{DEP} is selectively applied between the compensation region 21 and the bias region 4. This may be achieved by connecting a switch S_{DEP} in series with the voltage source that provides the bias voltage V_{DEP}. The switch SW_{DEP}, which is also referred to as bias switch in the following, is connected between the voltage source and the bias region 4 in the example shown in Figure 1. This, however, is only an example. The bias switch SW_{DEP} may be arranged at any position between the compensation region 21 and the drift region 11. Some examples for implementing the bias switch SW_{DEP} are explained herein further below.

According to one example, a magnitude of the bias voltage V_{DEP} is less than 20%, less than 10%, or even less than 5% of a voltage blocking capability of the superjunction transistor device. The "voltage blocking capability" is the maximum voltage the superjunction transistor device can withstand in the blocking state before an Avalanche breakdown occurs. According to one example, the voltage blocking capability is between 400V and 1500V. The magnitude of the bias voltage is between 10 volts (V) and 50 volts, in particular between 15 volts and 25 volts, for example.

In an n-type transistor device, a polarity of the bias voltage V_{DEP} may be such that (when the optional bias switch SW_{DEP} is in an on-state) the electrical potential of the bias region 4 is positive relative to the electrical potential at the compensation region 21.

Applying the bias voltage V_{DEP} between the compensation region 21 and the bias region 4, when the transistor device 1 is in the diode state, helps to reduce losses when the transistor device changes from the diode state to the blocking state. Losses that occur when the transistor device changes from the diode state to the blocking state include losses that are associated with removing the charge carrier plasma from the drift region 11 and the compensation region 21 and losses that are associated with storing charge carriers in the junction capacitance explained above (the losses associated with storing charge carriers in the junction capacitance are sometimes referred to as Qoss losses). Storing charge carriers in the junction capacitance is associated with a depletion region (space charge region) expanding in both the drift region 11 and the compensation region 21. The charge carrier plasma includes first type charge carriers injected by the drain region 13 and second type charge carriers injected by the body region 22 and the compensation region 21. In an n-type transistor device, for example, the first type charge carriers are electrons (n-type charge carriers) and the second type charge carriers are holes (p-type charge carriers).

Referring to the above, the bias voltage V_{DEP} is applied between the bias region 4 and at least one of the compensation region 21 and the body region 22 (the compensation region 21 and/or the body region 22). Applying the bias voltage V_{DEP} between the bias region 4 and at least one of the compensation region 21 and the body region 22 such that at least one of the second pn-junction and the first pn-junction is reverse biased has the effect that first type charge carriers (those resulting from the charge carrier plasma in the drift region 11 and the compensation region 21 and/or the body region 22 and those associated with charging the junction capacitance) are collected by the bias region 4 and flow via the bias node Q towards a first node of the voltage source providing the bias voltage V_{DEP}. Equivalently, second type charge carriers (those resulting from the charge carrier plasma in the drift region 11 and compensation region 21 and/or the body region 22 and those associated with charging the junction capacitance) flow via the compensation region 21 and/or the body region 22 to a second node opposite the first node of the voltage source. In an n-type transistor device, for example, the polarity of the bias voltage V_{DEP} is such that the potential at the first node of the voltage source is higher than the potential at the second node in order to reverse bias the second pn-junction and/or the first pn-junction. In this case, electrons of the charge carrier plasma flow towards the first node of the voltage source and holes flow towards the second node of the voltage source.

Removing charge carriers of the charge carrier plasma from the drift region 11 and at least one of the compensation region 21 and the body region 22 and charging the junction capacitance (that is, forming a depletion region in the drift region 11 and the compensation region 21) in the way explained above is associated with losses, wherein these losses are dependent on the current associated with removing the charge carriers of the plasma and forming the depletion region and are dependent on the bias voltage V_{DEP}. This current is referred to as current associated with a transition from the diode state to the blocking state. By suitably adjusting the voltage level of the bias voltage V_{DEP} however, these losses can significantly be reduced as compared to losses occurring in a conventional superjunction transistor device with the same voltage blocking capability and the same on-resistance (which is the resistance between the drain node and the source node in the forward conducting state).

The depletion voltage V_{DEP}, at least, is applied between the compensation region 21 and the bias region 4 when the transistor device is in a transient phase between the reverse conducting state and the blocking state. The transient phase may include that the transistor device is operated in the diode state. It may be desirable to operate the transistor device in the diode state as short as possible and, nevertheless, avoid a cross current. A cross current may occur when the voltage across the transistor has reversed its polarity and the transistor device is still in the on-state..

According to one example, the bias voltage V_{DEP} is applied in the transient phase until the drain-source voltage V_{DS} in the blocking state has reached a predefined threshold. The transistor arrangement may further include a drive circuit (not illustrated) that is configured to drive the bias switch SW_{DEP} such that the bias switch SW_{DEP} is switched on until the drain-source voltage V_{DS} in the blocking state has reached the predefined threshold. The bias voltage V_{DEP} may be applied between the bias region 4 and the compensation region 21 throughout the time period in which the transistor device is in the diode state or only for a predefined time period, such as less than 100 nanoseconds (ns) before the transition from the diode state to the blocking state takes place and, as mentioned above, during the transition. According to one example, the predefined time period is dependent on a load current that flows through the superjunction transistor device when the transistor device is in the diode state, wherein a duration of the time period increases as the load current increases.

According to another example, the bias switch SW_{DEP} is operated synchronously with the superjunction transistor device such that (a) the bias switch SW_{DEP} switches off each time the superjunction transistor device switches on, that is, each time the superjunction transistor device is either in the forward conducting state or the reverse conducting state, and (b) the bias switch SW_{DEP} switches on each time the superjunction transistor device switches off, that is, each time the superjunction transistor device is either in the diode state or the blocking state.

Referring to the above, Figure 1 schematically illustrates device regions included in the superjunction transistor device, rather than a specific implementation. More detailed examples of how these device regions may be arranged in the semiconductor body 100 and of how the superjunction transistor device may be implemented are explained in the following.

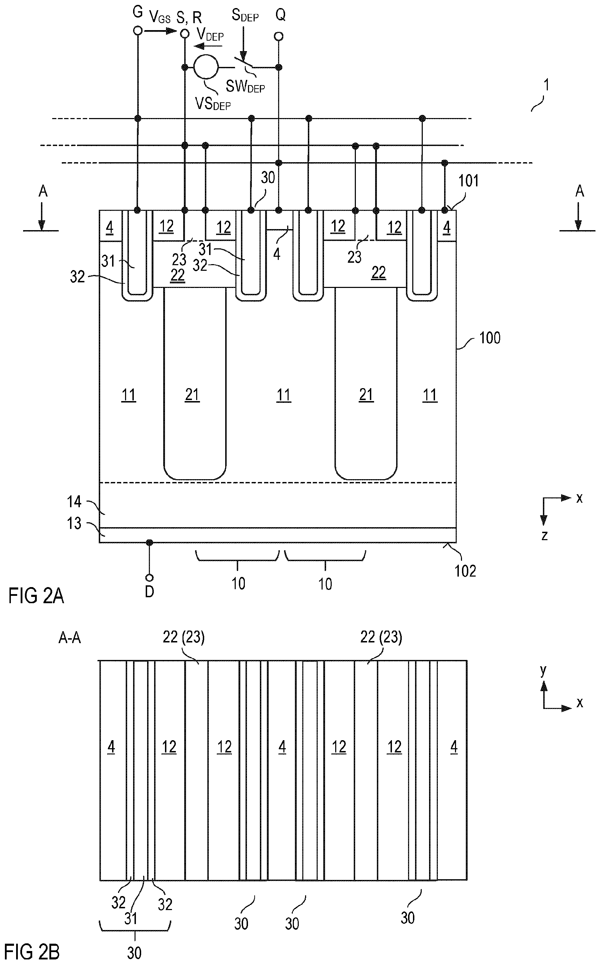

One example of the transistor device is illustrated in Figures 2A and 2B, wherein Figure 2A shows a vertical cross sectional view of a semiconductor body 100 in which the transistor device is integrated and Figure 2B shows a horizontal cross sectional view. The transistor device according to Figures 2A and 2B includes a plurality of transistor cells 10, wherein each transistor cell 10 includes device regions of the type explained with reference to Figure 1. That is, each transistor cell 10 includes: a drift region 11; a source region 12; a body region 22 separating the source region 12 from the drift region 11 and adjoining the drift region 11; a drain region 13 spaced apart from the body region 22 in a current flow direction; an optional buffer region 14; and a gate electrode 31 arranged adjacent to the body region 22 and dielectrically insulated from the body region 22 by a gate dielectric 32. Further, in the example shown in Figure 1 each transistor cell 10 further includes a bias region 4. Everything explained above with regard to the doping type and the doping concentration of the device regions illustrated in Figure 1 applies accordingly to the corresponding device regions in the transistor device shown in Figures 2A and 2B and the other transistor devices explained herein further below.

The transistor device shown in Figures 2A and 2B is a vertical transistor device. This, however, is only an example. A structure of the type illustrated in Figures 2A and 2B that includes a plurality of transistor cells may be used in a lateral transistor device as well.

Referring to Figure 1, the drift region 11 of two neighboring transistor cells 10 can be formed by one respective semiconductor region, the compensation region 21 of two neighboring transistor cells 10 can be formed by one respective semiconductor region, and the body region 22 of two neighboring transistor cells 10 can be formed by one respective contiguous semiconductor region. Further, the bias region 4 of two neighboring transistor cells 10 can be formed by one respective semiconductor region. Further, the drain region 13 (as well as the optional buffer region 14) of each of the transistor cells 10 can be formed by one contiguous semiconductor region.

In the example shown in Figures 2A and 2B, the gate electrodes 31 and the gate dielectrics are located in trenches that extend from the first surface 101 into the semiconductor body 100. The trenches with the gate electrodes 31 and the gate dielectrics 32 are referred to as gate trenches 30 in the following.

The transistor cells 10 are connected in parallel in that the gate electrodes 31 of the transistor cells 10 are connected to the gate node G, the source regions 12 and the body regions 22 of the transistor cells 10 are connected to the source node S, and the one or more drain regions 13 are connected to the drain node D. Further, each of the bias regions 4 is connected to the bias node Q. The gate node G, the source node S, the drain node D, and the bias node Q are only schematically illustrated in Figure 2A. Further, connections between the gate node G and the gate electrodes 31 and between the source node S, the drain node D and the bias node Q and the respective active device regions (source regions 12, body regions 22, drain regions 13, and bias regions 4) are only schematically illustrated in Figure 2A. These connections may include metallizations (not shown) on top of the first and second surfaces 101, 102.

Referring to the above, the body regions 22 of the transistor cells 10 are connected to the source node S. According to one example, the body region 22 includes a contact region 23 of the second doping type, wherein the contact region 23 is more highly doped than remaining sections of the body region 22. In particular, the contact region 23 is more highly doped than those sections of the body region 22 adjoining the gate dielectric 32. The contact region 23 may serve to provide an ohmic contact between the source node S and the respective body region 22, more specifically, between the body region 22 and a source metallization (not illustrated).

In the transistor device shown in Figures 2A and 2B, the compensation regions 21 of the transistor cells 10 are connected to the source node S. For this, the compensation region 21 of each transistor cell 10 adjoins the respective body region 22 in the vertical direction of the semiconductor body 100. In lateral directions, the compensation regions 21 are spaced apart from the gate trenches 30.

In the transistor device shown in Figures 2A and 2B, the transistor cells are arranged such that the semiconductor region forming the bias region 4 of two neighboring transistor cells 10 is located between the gate trenches of these transistor cells. Further, in this example, each transistor cell 10 includes a bias region 4. This, however, is only an example. According to another example (not shown), some of the bias regions 4 are omitted. In this case, neighboring transistor cells that each do not include a bias region may be implemented with a joint gate electrode.

Referring to Figure 2B, the transistor cells 10 may be elongated in a lateral direction that is perpendicular to the section plane illustrated in Figure 2A. Figure 2B shows a horizontal cross sectional view of the semiconductor body 100 in a section plane A-A shown in Figure 2A. In the following, a lateral direction x, which is a direction in which the body regions 22 adjoin the respective gate trenches 30 is referred to as first lateral direction x in the following. A lateral direction perpendicular to the first lateral direction x is referred to as second lateral direction y. Referring to Figure 2B, the transistor cells 10 may be elongated in the second lateral direction y. "Elongated" means, for example, that a dimension of the drift regions 11 (or compensation regions 21) in the second lateral direction y is at least one 100 (=1E2) times, or at least one 1000 (=1E3) times, the dimension of the drift regions 11 (or the compensation regions 21) in the first lateral direction x.

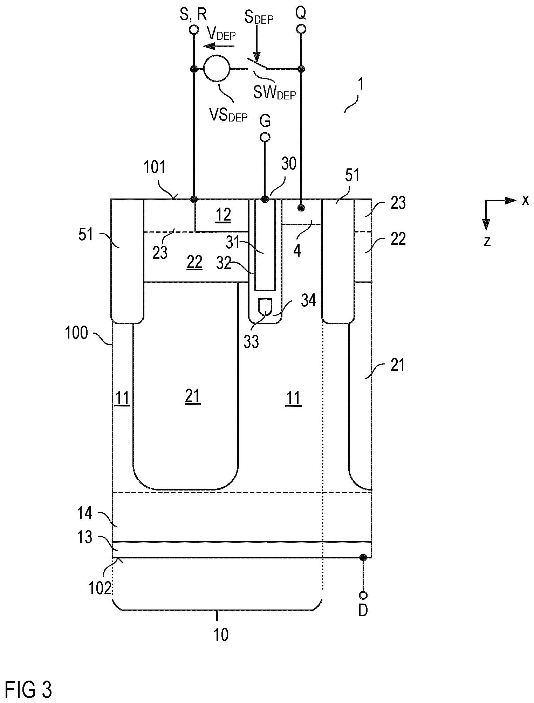

Figure 3 illustrates a modification of the transistor device shown in Figure 2. In the transistor device shown in Figure 3, the body region 22 of each transistor cell 10 (wherein only one transistor cell is shown in Figure 3) is arranged between a respective gate trench 30 and a first isolation trench 51. The compensation region 21 adjoins the body region 22, is spaced apart from the gate trench 30 and may adjoin the isolation trench 51. The bias region 4 of each transistor cell 10 is arranged between the gate trench 30 of the respective transistor cell 10 and the first isolation trench 51 of a neighbouring transistor cell (a section of the neighbouring transistor cell is illustrated in Figure 3).

Optionally, the transistor cell 10 further includes a field electrode 33. The field electrode 33 is arranged in the gate trench 30 below the gate electrode 31 (as seen from the first surface 101), is arranged adjacent to the drift region 11 and is dielectrically insulated from the drift region 11 by a field electrode dielectric 34. The field electrode dielectric 34 electrically insulates the field electrode 33 from the drift region 11. In a way not illustrated in detail in Figure 3, the field electrode 33 may be connected to the gate node G, the source node S or the bias node Q. The field electrodes 33 are useful to adjust a gate-drain capacitance of the transistor device, wherein the gate-drain capacitance is a capacitance between the gate node G and the drain node D of the transistor device. According to one example, the field electrode 33 is connected to the source node S to achieve a low gate-drain capacitance. According to another example, the field electrode 33 is connected to the gate node G to achieve a higher gate-drain capacitance.

The first isolation trench 51 is a trench extending from the first surface 101 into the semiconductor body 100 and electrically insulates the bias region 4 and the drift region 11 of one transistor cell from the body region 22 and the optional contact region 23 of a neighbouring transistor cell. The first isolation trench 51 may include any kind of electrically insulating material. Examples for implementing the first isolation trench 51 are explained in detail herein further below.

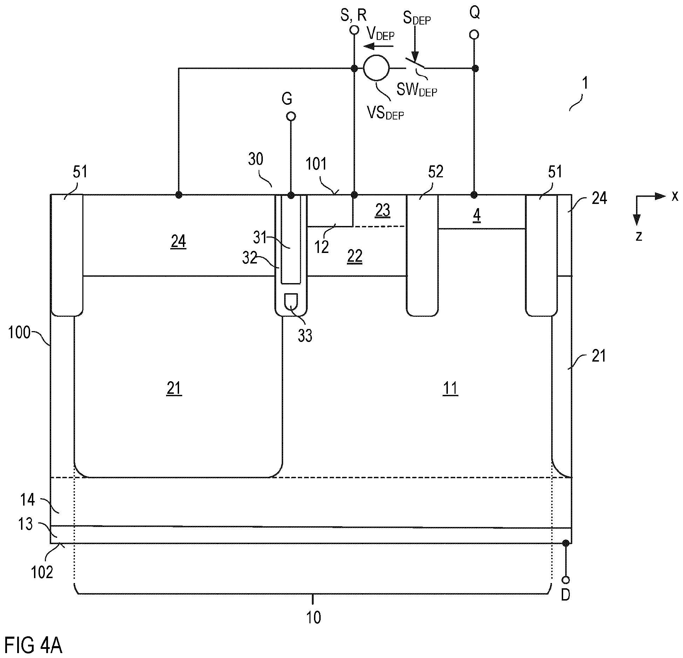

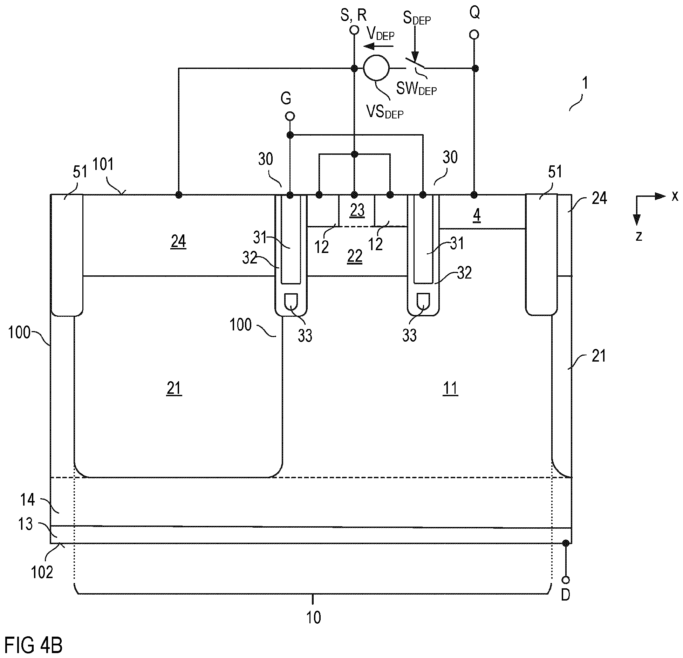

Figure 4A illustrates a modification of the transistor device shown in Figure 3. The transistor device shown in Figure 4 is different from the transistor device shown in Figure 3 in that the compensation region 21 is spaced apart from the body region 22. The compensation region 21 is either directly connected to the source node S or is connected to the source node S via a contact region 24 (as illustrated in Figure 4), wherein the contact region 24 adjoins the compensation region 21 and has a higher doping concentration than the compensation region 21. A doping concentration of the contact region 24 is high enough to obtain an ohmic contact between the contact region 24 and the source node S.

In the example shown in Figure 4A, at least one of the compensation region 21 and the contact region 24 may adjoin the gate trench 30 on one side, wherein the body region 22 and the source region 12 adjoin the gate trench 30 on another side opposite the at least one of the compensation region 21 and the contact region 24. The field electrode 33 in the gate trench 30 below the gate electrode 31 is optional and may be omitted.

Further, in the transistor device shown in Figure 4A, the bias region 4 is separated from the body region 22 (and the optional contact region 23) by a second isolation trench 52. The bias region 4 of one transistor cell is separated from the compensation region 21 and the optional contact region 24 of a neighbouring transistor cell by the first isolation trench 51.

Figure 4B illustrates a modification of the transistor device shown in Figure 4A. The transistor device shown in Figure 4B is different from the transistor device shown in Figure 4A in that it includes a further gate trench 30 instead of the second isolation trench 52 between the body region 22 and the bias region 4. Further, the transistor device shown in Figure 4B includes a further source region 12 connected to the source node S and adjoining the further gate trench 30.

The first and second isolation trenches 51, 52 may be implemented in various ways. Two examples for implementing these isolation trenches 51, 52 are illustrated in Figures 5A and 5B. The first and second isolation trenches 51, 52 of one transistor cell 10 may be implemented in the same way or in different ways. In context with Figures 5A and 5B, "isolation trench" relates to any one of the first and second isolation trenches 51, 52.

According to one example illustrated in Figure 5A, the isolation trench 51, 52 may completely filled with an electrically insulating material 53. Examples of the electrically insulating material include an oxide, a nitride, or combinations thereof. According to another example illustrated in Figure 5B, a void 54 filled with air or a noble gas, for example, is arranged within the electrically insulating material 53.

Optionally, in the example illustrated in Figure 5A as well as in the example illustrated in Figure 5B, the isolation trench 51, 52 may include an electrode 55 in the region of a bottom of the isolation trench 51, 52. The electrode 55 is surrounded by the electrically insulating material 53 and may be connected to one of the gate node G, the source node S, or the bias node Q. An electric field along the first surface 101 in the bias region 4 and a current density in a region along the isolation trench 51 is dependent on to which of the circuit nodes (G, S, or Q) the field electrode 33 is connected to. According to one example, in the transistor device according to Figures 4A and 4B, the isolation trench 51 includes a field electrode 55 connected to the bias node Q.

In each of the examples explained above, the bias region 4 may be implemented as a doped semiconductor region of the second doping type. In this case, a pn-junction is formed between the bias region 4 and the drift region 11 in the examples explained above. This pn-junction prevents a current flow from the drain region 11 to the bias node Q when the transistor device is in the blocking state and the drain source-voltage V_{DS} increases. On the other hand, when the bias switch SW_{DEP} is switched on, a bias region 4 of the second doping type injects second type charge carriers (which are holes in an n-type transistor device) into the drift region 11 that flow via the compensation region 21 and/or the body region 22 to the bias voltage source VS_{DEP}. This current flow is associated with additional losses.

Such losses can be reduced by suitably selecting the doping concentration of the bias region 4. The bias region 4 can be considered as an emitter of a bipolar transistor formed by the bias region 4, the drift region 11 and the compensation and body regions 21, 22. According to one example, a doping concentration of the bias region 4 is less than 5E18 cm⁻³ to achieve a rather low efficiency of this emitter, that is, to suitably limit the amount of charge carriers injected into the drift region 21 by the emitter. According to one example, the doping concentration of the bias region 4 is between 1E16 cm⁻³ and 2E18 cm⁻³.

Furthermore, such losses can be widely prevented when implementing the bias region 4 as a doped region of the first doping type. Thus, in each of the examples explained above, the bias region 4 may be also implemented as a doped semiconductor region of the first doping type. A current flow between the drain region 11 and the bias node Q can be prevented in this case by switching of the bias switch SW_{DEP} in due time when the transistor device is in the blocking state and the drain source-voltage V_{DS} increases or by any other means that interrupt a current flow from the drain region 11 to the bias region 4 when the transistor device 1 is in the blocking state. These other means may include means that interrupt a current path below the bias region 4 in the mesa region between the trenches 30 or 51, 52.

According to one example illustrated in Figure 6, the bias region 4 is a doped region 41 of the first doping type. In this example, a diode 6 may be connected between the bias region 4 and the bias voltage source VS_{DEP}. In Figure 6, only the circuit symbol of the diode 6 is illustrated. Examples for implementing this diode 6 are explained herein further below. The diode 6 helps to prevent a current flow between the drain node D (not illustrated in Figure 6) and the source node S via the drift region 11 and the bias region 4 when the transistor device is in the blocking state and the bias switch SW_{DEP} is switched on.

Figure 6 only illustrates the bias region 4 and two trenches between which the bias region 4 is located. These trenches may include two gate trenches 30 as illustrated in Figure 2A, a gate trench 30 and a first isolation trench 51 as illustrated in Figure 3 or a first isolation trench 51 and a second isolation trench 52 as illustrated in Figure 4. These trenches are only schematically illustrated in Figure 6 and may be implemented in accordance with any of the examples explained above.

Optionally, as illustrated in dashed lines in Figure 6 a doped region 43 of the second doping type is connected between the diode 4 and the drift region 11 and adjoins the bias region 4. This region 43 of the second doping type may be useful, in addition to the body region 22, to divert minority charge carriers from the drift region 11 when the transistor device changes from the diode state to the blocking state. The diode 6 may be any kind of external diode connected between the bias voltage source VS_{DEP} and the bias region 4.

According to one example illustrated in Figure 7, the diode 6 is a Schottky diode and is formed by the bias region 4 and a Schottky metal layer 61 adjoining the bias region 4. The Schottky metal layer 61 may include at least one of titanium (Ti), molybdenum (Mo), molybdenum silicide (MoSi), tantalum (Ta), titanium silicide (TiSi), or tantalum silicide (TaSi). The Schottky diode prevents a current flow from the drift region 11 to the bias node Q when the transistor device is in the blocking state and the drain-source voltage increases. This is similar to the example in which the bias region 4 is of the second doping type so that a pn-junction is formed between the bias region 4 and the drift region 11. Unlike a bias region 4 of the second doping type, however, the Schottky diode formed by the bias region 4 of the first doping type and the Schottky metal does not inject second type charge carriers into the drift region 11.

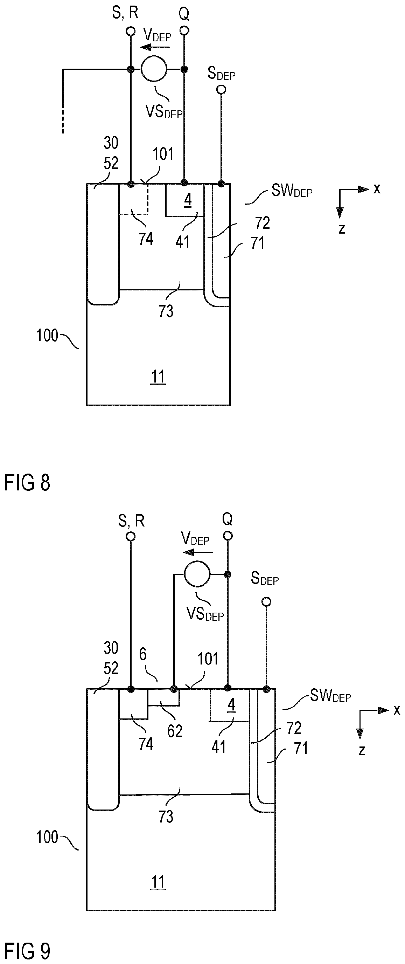

According to one example, the bias switch SW_{DEP} is integrated in the semiconductor body 100. Examples for integrating the bias switch SW_{DEP} in the semiconductor body 100 are explained with reference to Figures 8 to 10 in the following. In each of these examples, the bias switch SW_{DEP} includes an auxiliary MOSFET integrated in the semiconductor body 100.

In the example illustrated in Figure 8, the auxiliary MOSFET includes a gate electrode 71 arranged in a trench of the semiconductor body 100 and dielectrically insulated from semiconductor regions of the semiconductor body 100 by a gate dielectric 72. The bias region 4 is a region 41 of the first doping type and forms a first source or drain region of the auxiliary MOSFET. The drift region 11 forms a second source or drain region of the auxiliary MOSFET. A body region 73 of the second doping type is arranged between the bias region 4 and the drift region 11. Optionally, the source node S is connected to the body region 73, wherein an optional contact region 74 may provide for an ohmic contact between the source node S and the body region 73.

Figure 9 shows a modification of the arrangement shown in Figure 8. In the example illustrated in Figure 9, the diode 6 is also integrated in the semiconductor body 100. In this example, the diode 6 is formed by a pn-junction between the contact region 74 of the second doping type, which is also referred to as first diode region in the following, and a second diode region 62 of the first doping type. The bias voltage source VS_{DEP} is connected between the second diode region 62 and the bias region 4 in this example. In each of the examples illustrated in Figures 8 and 9, the auxiliary MOSFET of the bias switch SW_{DEP} is a MOSFET of the first conductivity type.

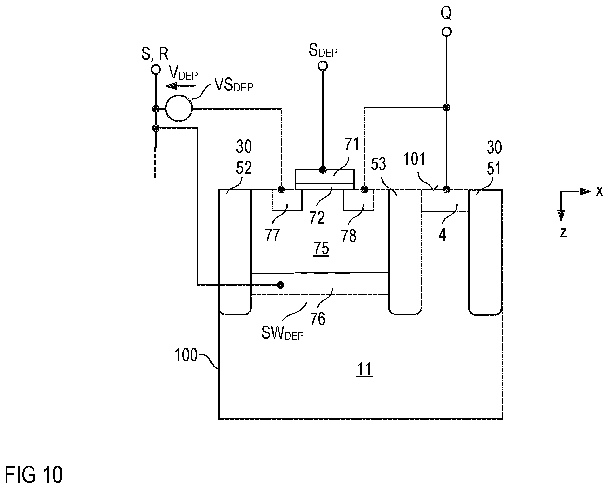

Figure 10 illustrates another example of the bias switch SW_{DEP}. In this example, the auxiliary MOSFET of the bias switch SW_{DEP} is a lateral MOSFET. The gate electrode 71 is arranged on top of the first surface 101 of the semiconductor body 100 and is dielectrically insulated from the semiconductor body 100 by the gate dielectric 72. The MOSFET is of the second conductivity type in this example and includes a body region 75 of the first doping type and source and drain regions 77, 78 of the second doping type. These source and drain regions 77, 78 are spaced apart from each other in a lateral direction of the semiconductor body 100. One of the source and drain regions 77, 78 is connected to the bias voltage source VS_{DEP}. The other one of the source and drain regions 77, 78 is connected to the bias region 4, wherein the bias region 4 is separated from the semiconductor regions of the bias switch SW_{DEP} by a third isolation trench 53. This third isolation trench 53 may be implemented in accordance with one of the examples illustrated in Figures 5A and 5B.

Referring to Figure 10, a junction region 76 of the second conductivity type forms a junction isolation between the body region 75 of the auxiliary MOSFET and the drift region 11. This junction region 76 extends from the gate trench 30 or the second isolation trench 52 on one side to the third isolation trench 53 on the other side. The junction region 76 is connected to the source node, for example. A connection between the junction region 76 and the source node S is only schematically illustrated in Figure 10.

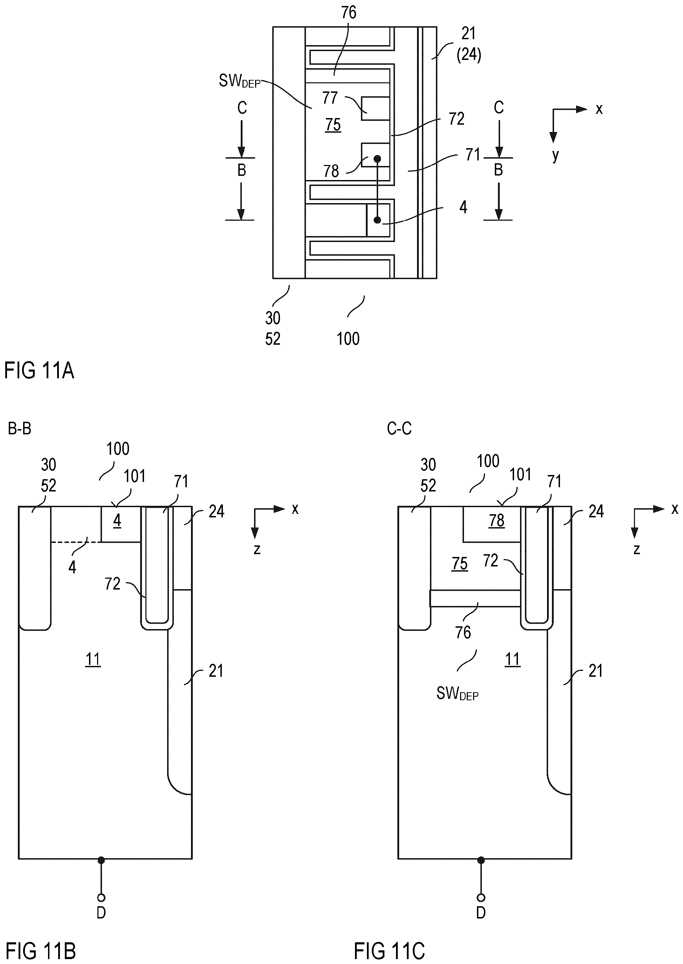

In the example illustrated in Figure 10, the source and drain regions 77, 78 of the auxiliary MOSFET of the bias switch SW_{DEP} are spaced apart from each other in the first lateral direction x and the bias region 4 is spaced apart from the semiconductor regions forming the bias switch SW_{DEP} in the first lateral direction x. This, however, is only an example. Figures 11A to 11C illustrate a modification of the transistor arrangement shown in Figure 10, wherein Figure 11A shows a horizontal cross sectional view of a section of the semiconductor body 100 in which the bias switch SW_{DEP} and the bias region 4 are integrated, Figure 11B shows a vertical cross sectional view of a section in which the bias region 4 is integrated, and Figure 11C shows a vertical cross sectional view of a section in which one of the source and drain regions 77, 78 of the bias switch SW_{DEP} is integrated.

In the example illustrated in Figures 11A to 11C, the gate trench with the gate electrode 71 and the gate dielectric 72, in the horizontal cross sectional view, has the shape of a comb with fingers that, in the first lateral direction x, each extend to the gate trench 30 or the second isolation trench 52 of the transistor cell 10. Between two of these fingers of the gate structure 71, 72 the bias region 4 is arranged, and between two of these fingers the source and drain regions 77, 78, the body region 75 and the junction region 76 of the bias switch SW_{DEP} are arranged. The source and drain regions 77, 78 adjoin the gate dielectric 72 and are arranged spaced apart from each other in the second lateral direction y, that is, the direction that is essentially parallel to the longitudinal direction of the gate trench 70 or the second isolation trench 52. The bias region 4 is spaced apart from the semiconductor regions forming the bias switch SW_{DEP} in the second lateral direction y.

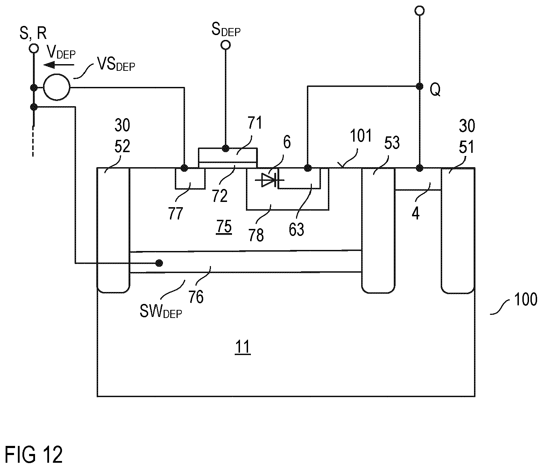

Figure 12 shows a modification of the arrangement shown in Figure 10. In the example shown in Figure 12, the diode 6 is integrated in the semiconductor body 100. More specifically, drain or source region 78 of the bias switch SW_{DEP} forms a first diode region and a second diode region 63 of the first doping type, which is a doping type complementary to the doping type of the source or drain region 78, is embedded in the source or drain region 78. The diode is formed by the pn-junction between the source or drain region 78 and the second diode region 63. The second diode region 63 is connected to the bias region 4.

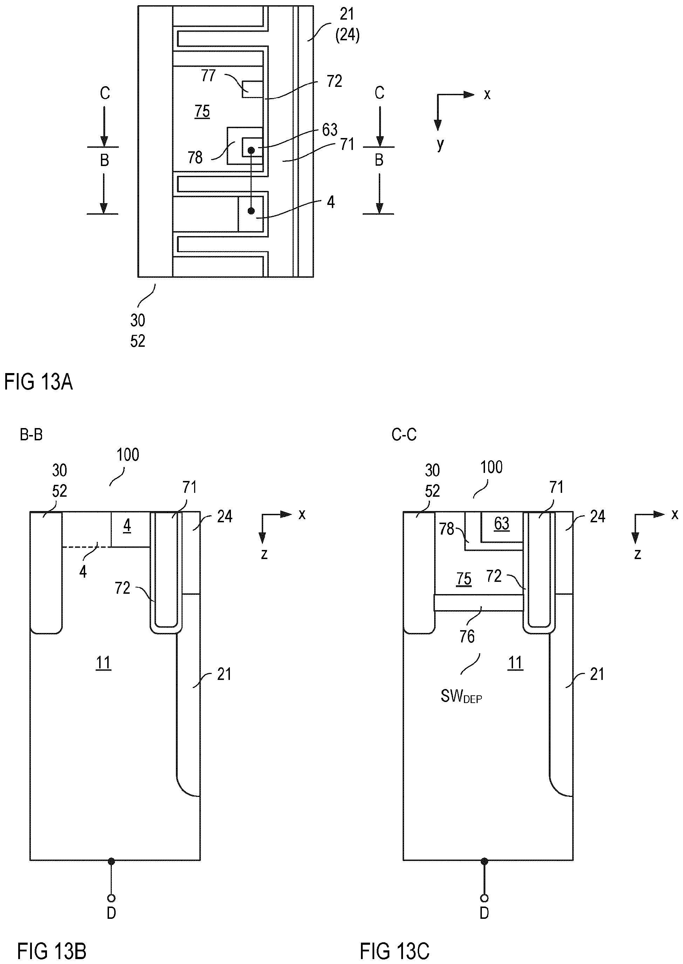

Figures 13A to 13C illustrate a modification of the arrangement shown in Figures 11A to 11C. The arrangement shown in Figures 13A to 13C is different from the arrangement shown in Figures 11A to 11C in that the diode 6 is integrated in the semiconductor body 100. For this, like in the example illustrated in Figure 12, the second diode region 63 is embedded in the source or drain region 78 and connected to the bias region 4.

In the examples illustrated in Figures 10, 11A to 11C, 12 and 13A to 13C, connections between the source or drain region 78 or the second diode region 63 and the bias region 4 are only schematically illustrated. These connections may be implemented in a conventional way using metallizations formed on top of the first surface 101 of the semiconductor body 100.

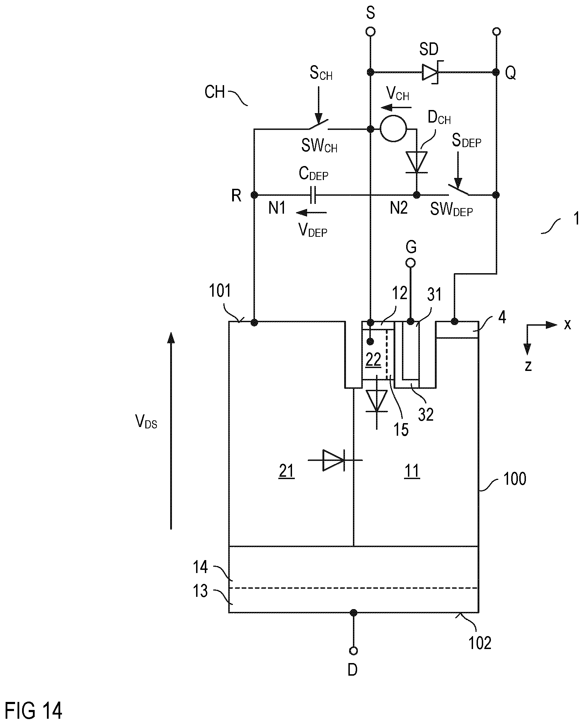

Figure 14 illustrates a modification of the transistor arrangement 1 shown in Figure 1 in which a current flow via the bias voltage source VS_{DEP} is prevented when the transistor device is either in the diode state or the reverse conducting state.

The transistor arrangement shown in Figure 14 is different from the transistor arrangement shown in Figure 1 in that the bias voltage V_{DEP} is provided by a capacitor C_{DEP} connected between the bias region 4 and the compensation region 21. This capacitor C_{DEP} is also referred to as bias capacitor in the following. The bias switch SW_{DEP} is represented by its circuit symbol in Figure 14. This bias switch SW_{DEP} may be implemented as an external device or may be integrated in the semiconductor body 100 in accordance with any of the examples explained herein before.

Referring to Figure 14, the transistor arrangement 1 further includes a charging circuit CH for charging the capacitor C_{DEP}. The charging circuit CH includes a charging voltage source configured to provide a charging voltage V_{CH} and a switch S_{CH} connected in series with the charging voltage source. A series circuit including the voltage source and the switch S_{CH} is connected in parallel with the bias capacitor C_{DEP}. A circuit node between the charging voltage source and the switch S_{CH} is connected to the source node S, so that the switch S_{CH} is connected between the source node S and a first node N1 of the bias capacitor C_{DEP} and the voltage source is connected between the source node S and a second node N2 of the bias capacitor C_{DEP}. In this way, the electrical potential at the second node N2 of the bias capacitor C_{DEP} is kept at a predefined voltage level, wherein this voltage level is essentially given by the electrical potential at the source node S and the charging voltage V_{CH}. The first node N1 of the bias capacitor C_{DEP} which is connected to the compensation region 21 is also referred to as second bias node R in the following.

According to one example, the charging switch SW_{CH} is operated in such a way that it is in the on-state to charge the bias capacitor C_{DEP} when the superjunction transistor device is in the forward conducting state or the reverse conducting state and in the off-state when the superjunction transistor device is in the diode state or the blocking state. In this way, a connection between the compensation region 21 and the source node S is interrupted when the transistor device is in the diode state. The bias voltage V_{DEP} is provide by the bias capacitor C_{DEP} via the bias switch SW_{DEP}. The bias switch SW_{DEP} may be operated in the same way as explained above. That is, the bias switch SW_{DEP} is switched on at least during a transient phase between the diode state and the blocking state and may be switched on throughout the diode state and the blocking state.

Optionally, a rectifier element D_{CH} such as a diode is connected between the charging voltage source and the second node N2 of the bias capacitor C_{DEP}. This rectifier element is connected such that it prevents a current flow from the bias region 4 via the bias switch SW_{DEP} and the voltage source to the source node S.

Optionally, a further rectifier element SD is connected between the source node S and the bias region 4. According to one example, this rectifier element SD is a Schottky diode. This rectifier element serves to limit a voltage between the source node S and the bias region 4 to a threshold level that is given by the forward voltage of the rectifier element SD. Alternatively (not illustrated) the optional further rectifier element is connected between the source node S and the circuit node between the bias capacitor C_{DEP} and the bias switch SW_{DEP}.

The circuit topology illustrated in Figure 14 with the charging capacitor C_{DEP}, the charging circuit CH and the optional rectifier element SD can be implemented in each of the transistor arrangements explained above. That is, the superjunction transistor device can be implemented in accordance with any of the superjunction transistor devices explained herein before.

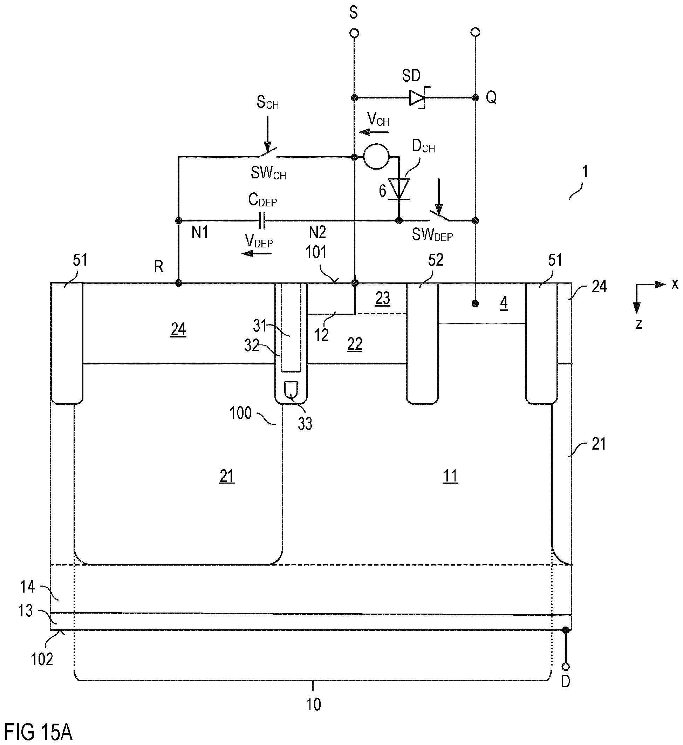

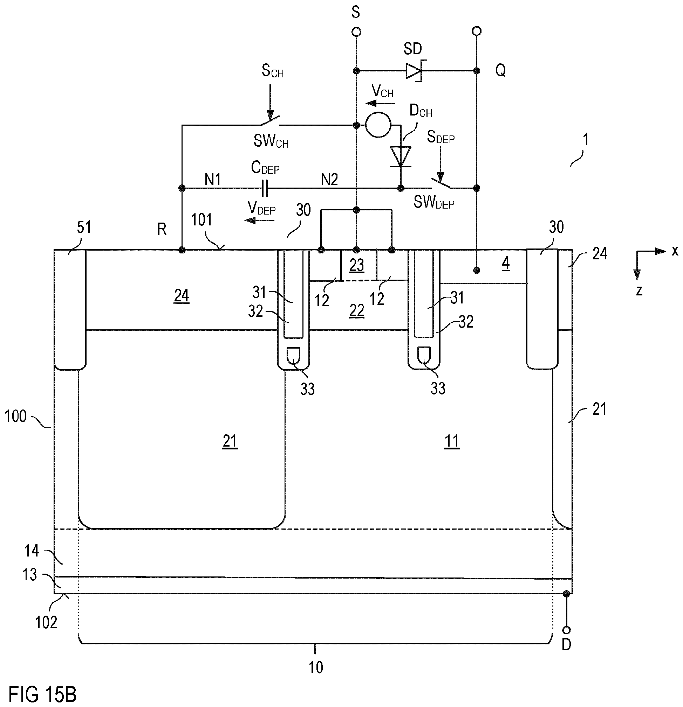

Figure 15A, for example, shows a transistor arrangement of the type shown in Figure 14 that includes a transistor arrangement of the type shown in Figure 4A. Figure 15B shows a transistor arrangement of the type shown in Figure 25 that includes a transistor device of the type shown in Figure 4B.

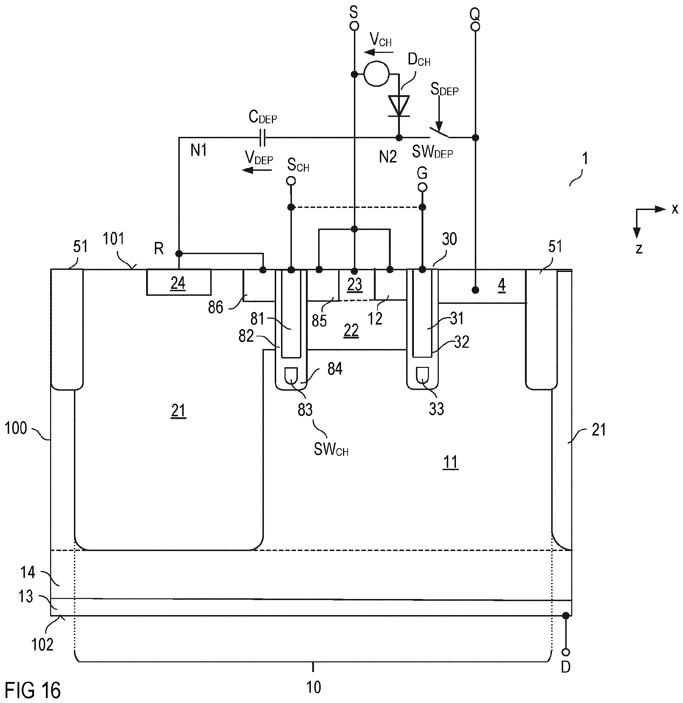

According to one example, the charging switch SW_{CH} is integrated in the semiconductor body 100. One example of a transistor arrangement 1 in which the charging switch S_{CH} is integrated in the semiconductor body 100 is illustrated in Figure 16. In this example, the charging switch SW_{CH} includes a MOSFET with a gate electrode 81 and a gate dielectric 82 that are arranged in a trench between the body region 22 and the compensation region 21. The trench with the gate electrode 81 and the gate dielectric 82 extends from the first surface 101 adjacent to the body region 22 and a section of the compensation region 21 into the drift region 11. A first source or drain region 85 of the MOSFET is arranged in the body region 22, connected to the source node S and adjoins the trench with the gate electrode 81 and the gate dielectric 82 on one side. A second source or drain region 86 is connected to the first node N1 of the bias capacitor C_{DEP}, adjoins the trench with the gate electrode 81 and the gate dielectric 82 on a side opposite the side of the first source or drain region 85 and is arranged in the compensation region 21. The MOSFET forming the charging switch SW_{CH} switches on or of dependent on a drive signal S_{CH} received at the gate electrode 81. In the on-state of the MOSFET there is a conducting channel in the body region 22 between the first source or drain region 85 and the drift region 11 and another conducting channel in the compensation region 21 between the drift region 11 and the second source or drain region 86, so that in the on-state of the MOSFET there is a conducting channel between the first and second source or drain regions 85, 86. Thus, the source node S is connected to the second bias node R.

According to one example (illustrated by a dashed line in Figure 16), the gate electrode 81 of the charging switch SW_{CH} is connected to the gate node G. In this case, the charging switch SW_{CH} is switched on whenever the transistor device is in an on-state, that is, whenever the transistor device is in the forward conducting state or the reverse conducting state. Thus, the bias capacitor C_{DEP} is charged each time the transistor device is in the on-state. Further, in this case, each time the transistor device switches on, the charging switch SW_{CH} connects the compensation region 21 to the source node S and, therefore, causes the compensation region 21 to be discharged when the transistor device changes from the blocking state into the forward conducting state, for example. Such discharging of the compensation region 21 is useful to achieve a low on-resistance in the forward conducting state of the transistor device.

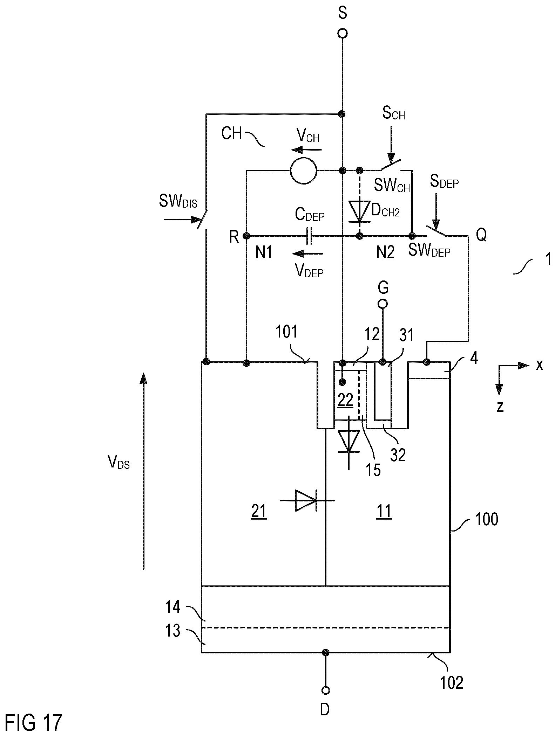

Figure 17 illustrates a modification of the transistor arrangement 1 shown in Figure 14. In the transistor arrangement 1 according to Figure 17, the charging voltage source is connected between the source node S and the second bias node R, which is connected to the compensation region 21. The charging switch S_{CH} is connected between the source node S and the second circuit node N2 of the bias capacitor C_{DEP}. Further, the transistor arrangement 1 includes a discharging switch SW_{DIS} connected between the compensation region 21 and the source node S The bias switch SW_{DEP} is connected between the bias region 4 and the second circuit node N2 of the bias capacitor C_{DEP}.

When the transistor device is in the blocking state the junction capacitance formed by the drift region 11 and the compensation region 21 is charged. Via the discharging switch SW_{DIS} the junction capacitance, more specifically, the compensation region 21 can be discharged when the transistor device changes from the blocking state to the forward conducting state. Otherwise the on-resistance would be relatively high. According to one example, the discharging switch SW_{DIS} is operated synchronously with the transistor device such that the discharging switch SW_{DIS} switches on each time the transistor device switches on to operate in the forward conducting state or the reverse conducting state, and such that the discharging switch SW_{DIS} switches off when the transistor device is in the diode state or the reverse conducting state. According to one example, the charging switch SW_{CH} only switches on in order to charge the capacitor C_{DEP} when the discharging switch SW_{DIS} is switched off. The charging switch SW_{CH} may be operated complementarily to the discharging switch SW_{DIS}, so that the charging switch SW_{CH} switches on when the discharging switch SW_{DIS} switches off and switches off when the discharging switch SW_{DIS} switches on.

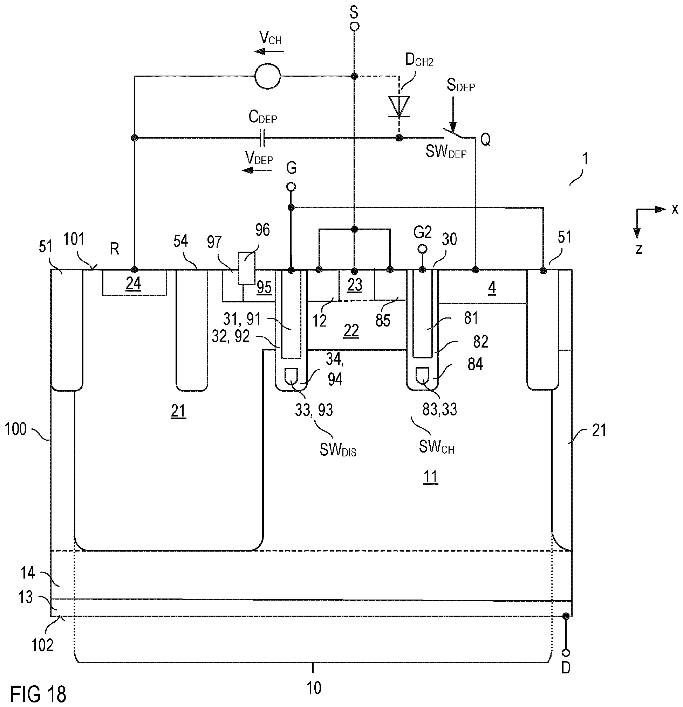

Figure 18 shows a vertical cross sectional view of an arrangement of the type shown in Figure 17, wherein the charging switch SW_{CH} and the discharging switch SW_{DIS} are integrated in the semiconductor body 100. Each of these switches SW_{CH}, SW_{DIS} is implemented as a MOSFET and includes a respective gate electrode 81, 91 connected to the gate node G of the superjunction transistor device so that operation of these switches SW_{CH}, SW_{DIS} is synchronized with operation of the superjunction transistor device. The discharging switch SW_{DIS} may be implemented such that it switches on and off synchronized with the superjunction transistor device so that this switch SW_{DIS} is in the on-state whenever the superjunction transistor device is in the forward conducting or the reverse conducting state. Referring to the above, the charging switch SW_{CH} may be operated such that it only switches on in order to charge the capacitor C_{DEP} when the discharging switch SW_{DIS} is switched off. Thus, in the example illustrated in Figure 18, the gate electrode 81 of the charging switch SW_{CH} is connected to a control node G2 that is different from the gate node G, wherein the gate electrode of the discharging switch SW_{DIS} is connected to the gate node G.

According to another example (not illustrated) the gate electrode 91 of the discharging switch SW_{DIS} is connected to a control node that is different from the gate node G. The gate electrode 91 of the discharging switch SW_{DIS} may be implemented in this way in addition to connecting the gate electrode 81 of the charging switch SW_{CH} to the gate node G2 so that the gate electrodes 81, 91 of the charging switch SW_{CH} and the discharging switch SW_{DIS} are connected to different control nodes. Alternatively, the gate electrode of the charging switch SW_{CH} is connected to the gate node G and the gate electrode 91 of the discharging switch SW_{DIS} is connected to a control node different from the gate node G.

In the arrangement shown in Figure 18, the charging switch SW_{CH} is implemented as explained with reference to Figure 16, wherein the gate electrode 81 of the charging switch SW_{CH} and one gate electrode 31 of the of the superjunction transistor device are formed by the same gate electrode. Furthermore, the gate electrode of the charging switch SW_{CH} is arranged between the bias region 4 and the body region 22.

The gate electrode 91 of the discharging switch SW_{DIS} and one gate electrode 31 of the of the superjunction transistor device connected to different gate electrodes G G2. Furthermore, the gate electrode of the discharging switch SW_{DIS} is arranged between the body region 22 and the compensation region 21. The discharging switch SW_{DIS} is a MOSFET of the first conductivity type, and includes a source region 95 of the first doping type, wherein the source region 95 is embedded in the compensation region 21 and adjoins the trench with the gate electrode 91. A body region of the discharging switch SW_{DIS} is formed by a section of the compensation region 21 that adjoins the gate trench, and a drain region of the discharging switch SW_{DIS} is formed by the drift region of the superjunction transistor device.

The discharging switch SW_{DIS} further includes a charge carrier converter that is configured to "convert" a second type charge carrier current provided by the compensation region 21 into a first type charge carrier current that can be conducted by the discharging switch SW_{DIS} to the drift region 11 in order to discharge the compensation region 21. The charge carrier converter includes the source region 95, a metal 96 adjoining the source region 95, and a region 97 of the second doping type. The region of the second doping type adjoins the metal and may adjoin the source region 95. The region of the second doping type 97 is embedded in the compensation region 21 and has a doping concentration that is higher than the doping concentration of the compensation region 21.

Optionally, an isolation trench 54 is arranged between the charge carrier converter 95, 96, 97 and the contact region 24 of the compensation region. This isolation trench 54 may be implemented in accordance with any of the examples explained with regard to isolation trenches 51, 52 herein above.

In the examples explained before, the gate electrodes 31 of the transistor cells 10 of the superjunction transistor are arranged in trenches of the semiconductor body 100. This, however, is only an example, it is also possible to implement the gate electrodes 31 as planar gate electrodes on top of the semiconductor body 100, although this is not illustrated in the drawings.

A superjunction transistor device includes a gate-drain-capacitance C_{GD}, which is a capacitance of the transistor device between the gate node G and the drain node D. A capacitance value of this gate-drain-capacitance is dependent on the drain-source voltage V_{DS}, wherein in a conventional superjunction transistor device this capacitance value significantly varies over the drain-source voltage V_{DS}. More specifically, when the transistor device switches off and the drain-source voltage V_{DS} increases this capacitance value, at first, rapidly decreases and then again increases. This is highly undesirable because this may cause "gate ringing" and an overvoltage across the gate dielectric. Gate ringing includes that, although a gate-source voltage V_{GS} is applied between the gate node G and the source node S that is supposed to switch off the transistor device, oscillation effects may occur that repeatedly switch on the transistor device for a short time period.

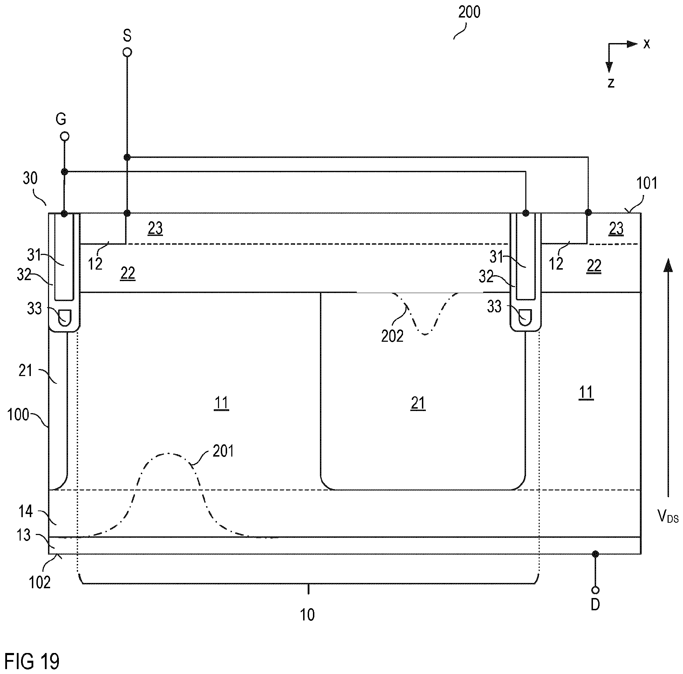

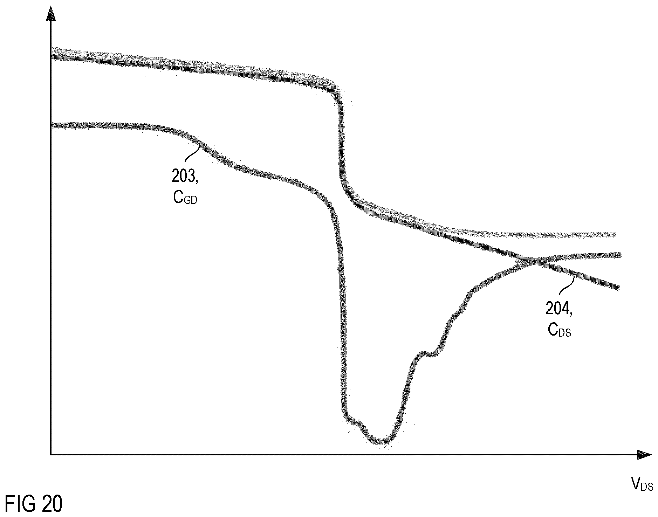

Figure 19 shows a vertical cross sectional view of a conventional superjunction transistor device, and Figure 20 illustrates the gate-drain-capacitance C_{GD} (curve 203) and the drain-source-capacitance C_{DS} (curve 204) of the conventional superjunction transistor device dependent on the drain-source voltage V_{DS}. In Figure 20, the capacitances C_{GD}, C_{DS} and the drain-source voltage V_{DS} are each drawn on a logarithmic scale.

Referring to Figure 19, the conventional superjunction transistor device may include a plurality of transistor cells 10, wherein one of these transistor cells 10 is illustrated in Figure 19. Like the superjunction transistor device explained herein above, the conventional superjunction transistor device includes a drift region 11, a compensation region 21, a body region 22, a source region 12, and a drift region 13. Optionally, a buffer region 14 is arranged between the drift and compensation regions 11, 21 and the drain region 13. In Figure 19 same reference numbers are used to denote same regions or portions of the transistor device as in the examples explained herein above. Everything explained herein above with regard to the drift, compensation, body, source, drain and buffer regions 11, 21, 22, 12, 13 and 14 applies to the respective regions shown in Figure 19 equivalently. Referring to Figure 19, the drain region 14 is connected to a drain node D of the transistor device and the source and body regions 12, 22 are connected to a source node S.

Further, the transistor device includes a gate electrode 31 which is arranged adjacent to the body region 22 and is dielectrically insulated from the body region 22 by a gate dielectric 32. In the example shown in Figure 19, the gate electrode 31 is arranged in a gate trench that extends from the first surface 101 of the semiconductor body 100 into the semiconductor body 100. Optionally, a field electrode 33 is arranged in the gate trench below the gate electrode 31. This field electrode 33 may be coupled to the gate node G. A connection between the field electrode 33 and the gate node G, however, is not illustrated in Figure 19.

In the example shown in Figure 19, the gate trench is arranged such that it adjoins the compensation region 21. More specifically, the gate trench extends through the body region 22 into the drift region 11 and the compensation region 21 so that it adjoins one portion of the drift region 11 on one side and the compensation region 21 on an opposite side.

When the transistor device switches off and a drain-source voltage V_{DS} is applied between the drain node D and the source node S that reverse biases the pn-junction between the drift region 11 and the body region 22, a space charge region (depletion region) expands in the drift region 11 and the compensation region 21 beginning at the pn-junction between the drift region 11 and the compensation region 21. In the drift and compensation regions 11, 21 the depletion regions essentially expand in the first lateral direction x beginning at the pn-junction. In a superjunction transistor device with a voltage blocking capability of several hundred volts (V), such as 600V, for example, a drain-source voltage V_{DS} of several 10V, such as between 20V and 30V, may be sufficient to deplete a majority of the drift region 11 and the compensation region 21.

In Figure 19 reference number 201 denotes an equipotential line in the drift region 11 (and the optional buffer region 14) when the drain-source voltage V_{DS} has reached a voltage level at which a majority of the drift region 11 and the compensation region 21 has been depleted. In regions below this equipotential line 201 the drift region 11 has not yet been depleted, so that the electrical potential in this region essentially equals the drain potential. Equivalently, reference number 202 illustrates an equipotential line in the compensation region 21 when the drain-source voltage V_{DS} has reached a voltage level at which a majority of the drift region 11 and the compensation region 21 have been depleted. In a region above this equipotential line 202 the compensation region 21 has not yet been depleted, so that an electrical potential in this region essentially equals source potential. Between these equipotential lines 201, 202, however, the drift region 11 and the compensation region 21 have been depleted.

As can be seen from Figure 19, the non-depleted region of the compensation region 21 (which is the region between the equipotential line 202 and the body region 22), in the lateral direction x, is located between the gate trench and a section of the drift region 11 that is spaced apart from the section adjoined by the gate trench. This non-depleted region of the compensation region 21 "shields" the gate trench from the drift region section 11 that is spaced apart from the gate trench. This may have the effect that, when the drain-source voltage has reached a voltage level in which the situation illustrated in Figure 19 occurs, the gate-drain capacitance C_{GD} significantly drops, as illustrated in Figure 20. The gate-drain capacitance C_{GD} again increases as the drain-source voltage V_{DS} increases and the non-depleted regions illustrated in Figure 19 are depleted.

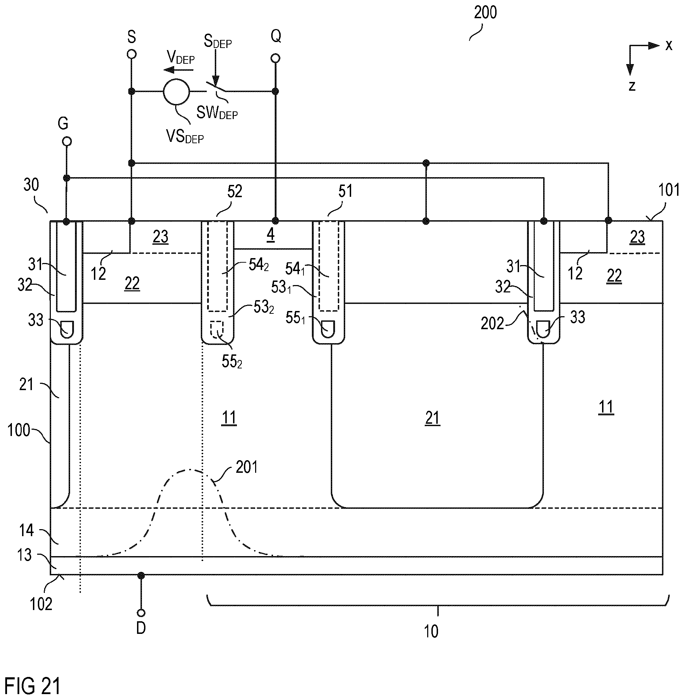

In Figure 20, a voltage range of the drain-source voltage V_{DS} in which the gate-drain capacitance C_{GD} significantly drops (dips) corresponds to a range of the drain-source voltage V_{DS} at which the situation illustrated in Figure 19 occurs. Such a "dip" of the gate-drain capacitance C_{GD} can be avoided in a transistor device of the type shown in Figure 21.

This transistor device is based on the transistor device shown in Figure 4A and includes a field electrode 55i in the first isolation trench 51, wherein the first field electrode 55₁ is connected to the bias node Q. The connection between the first field electrode 55₁ and the bias node Q, however, is not illustrated in Figure 21.

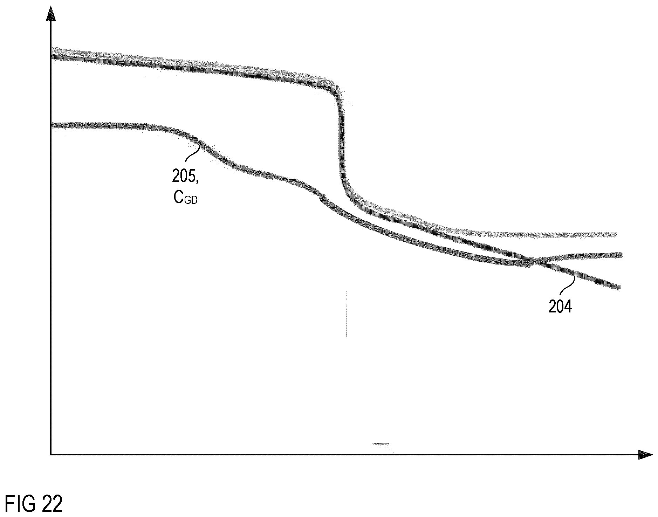

The first isolation trench 51 is spaced apart from the gate trench with the gate electrode 31 and adjoins the compensation region 21, so that the gate trench and the first isolation trench 51 adjoin the compensation region 21 on opposite sides. In this transistor device, when the transistor device switches off so that the drain-source voltage V_{DS} increases, the first field electrode 55₁ can be coupled to the bias voltage source VS_{DEP} by closing the bias switch SW_{DEP} so that the electrical potential of the first field electrode 55₁ is higher than the electrical potential at the source node S and the gate node G. This has the effect that, when the drain-source voltage V_{DS} increases, the equipotential line 202, which represents source potential, is "pushed" from the compensation region 21 into the gate trench. In this way, the shielding effect explained with reference to Figure 19 does not occur, so that the profile of the gate-drain capacitance C_{GD} is "linearized" as compared to the profile shown in Figure 20. The dependency of the gate-drain capacitance C_{GD} of the transistor device shown in Figure 21 on the drain-source voltage V_{DS} is illustrated in Figure 22, in which curve 25 illustrates the gate-drain capacitance C_{GD} dependent on the drain-source voltage V_{DS}.

The first isolation trench 51 may completely be filled with a dielectric 51i above the first field electrode 55₁. Optionally, a void 54i is arranged in the first isolation trench 51 above the first field electrode 55₁.

In addition to the first isolation trench 51 with the first field electrode 55i the transistor device shown in Figure 21 includes a bias region 4 connected to the bias node Q and a second isolation trench 52, wherein the bias region 4 is arranged between the first isolation trench 51 and the second isolation trench 52. The second isolation trench 52 may be implemented in accordance with any of the examples explained with reference to Figures 4A, 5A and 5B herein above. More specifically, the second isolation trench 52 may entirely be filled with a dielectric 53₂. Optionally, a second field electrode 55₂ is arranged in the second isolation trench 52 and dielectrically insulated from the semiconductor body 100 by the dielectric 53₂. According to another option, the second isolation trench 52 includes a void 54₂ above the second field electrode 55₂. With regard to the other features of the transistor device shown in Figure 21 everything explained with regard to the transistor device shown in Figure 4A applies accordingly.

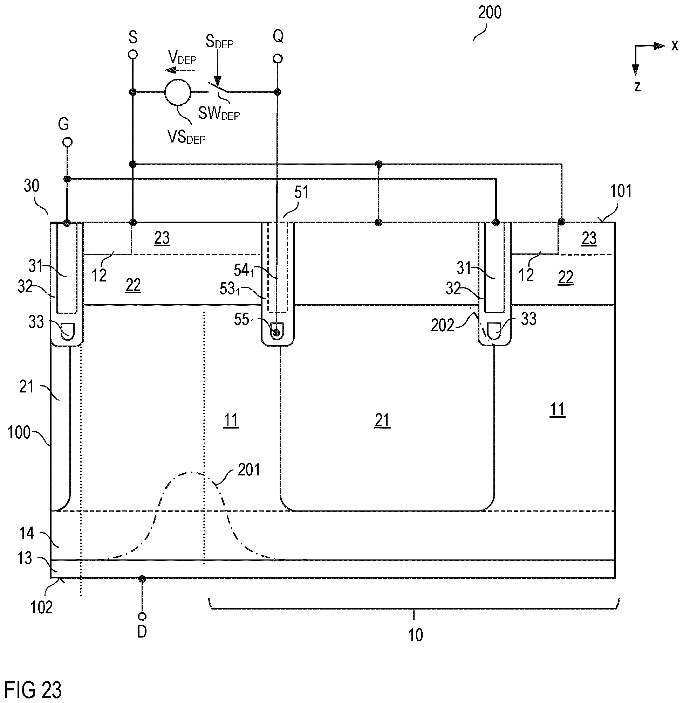

Figure 23 shows a modification of the transistor device shown in Figure 21. The transistor device of Figure 23 is different from the transistor device shown in Figure 21 in that the bias region 4 and the second isolation trench 52 are omitted, so that the first isolation trench 51 is arranged between the compensation region 21 of one transistor cell and the body region 22 and drift region 11 of a neighboring transistor cell. Like in the example illustrated in Figure 21, the bias node Q is connected to the first field electrode 55₁ and is coupled to the bias voltage source VS_{DEP}.

Referring to the above, in the transistor devices according to Figures 21 and 23 a more linear profile of the gate-drain capacitance C_{GD} can be obtained by applying an electrical potential higher than the gate or source potential to the first field electrode 55₁ when the transistor device is switched off and the drain-source voltage V_{DS} increases. In the examples illustrated in Figures 21 and 23 this electrical potential is provided by the bias voltage source VS_{DEP}.

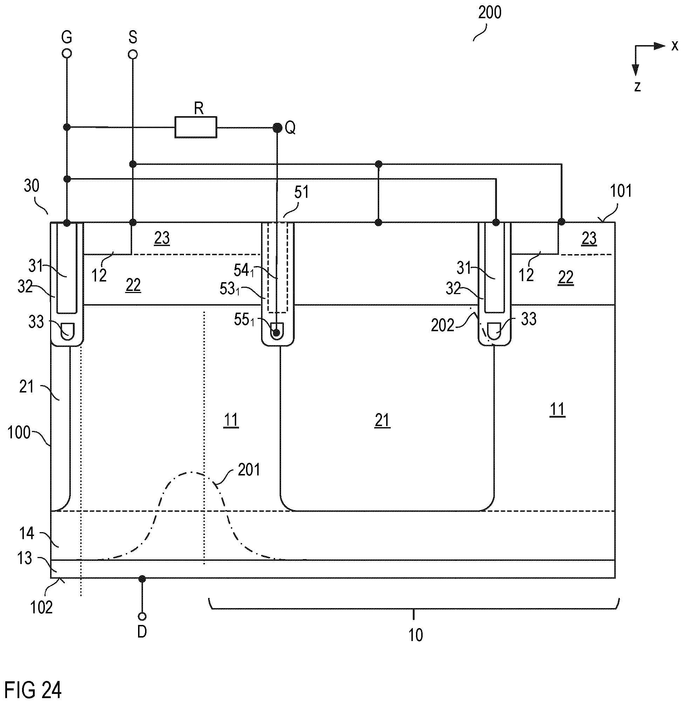

According to another example illustrated in Figure 24, the bias voltage source is omitted and the bias node Q is connected to the gate node G via a resistor R. A resistance of this resistor R is referred to as bias node resistance in the following. The bias node resistance is in the range of several 10 ohms to some kΩ, such as between 10 Ω and 1 kΩ, or between 50 Ω and 500 Ω, for example. Although not illustrated in Figure 24, there is an inevitable resistance between the gate node G and the gate electrode 31 of the transistor cell 10. This resistance results from a resistance of a connection line between the gate node G and the gate electrode 31 and is referred to as gate resistance. The bias node resistance is higher than the gate resistance. According to one example, the bias node resistance is between 1.2 times and 100 times gate resistance, in particular between 5 times and 50 times the gate resistance.

In the example shown in Figure 24, the bias node is a circuit node between the resistor R and the first field electrode 55₁. This bias node Q may be an internal circuit node that is not accessible from outside the semiconductor body 100. According to one example, the resistor R is integrated in the semiconductor body 100 and may include a doped semiconductor region.

For the purpose of illustration it is assumed that the transistor device is a n-type transistor device that switches on when the gate-source voltage V_{GS} is positive and higher than a threshold voltage. The first field electrode 55₁ forms a capacitor with the dielectric 53₁ and the compensation region 21 connected to the source node S. This capacitor is charged via the resistor R when the transistor device switches on and is discharged via the resistor R when the transistor device switches off. In this way, the electrical potential of the field electrode 55₁ follows the electrical potential at the gate node G. However, due to the resistor R, there is a delay time between a change of the potential at the gate node G and a corresponding change of the potential first field electrode 55i. Thus, when the transistor device switches off and the gate potential G falls to an off-level, the electrical potential at the first field electrode 55₁ remains on a higher level than the gate potential for a certain time period. This has the same effect as applying the bias voltage V_{DEP} to the first field electrode 55i.

A transistor arrangement of the type explained herein above that includes a superjunction transistor device with a drain node D, a source node S, and a gate node G and that further includes at least the bias node Q, the bias voltage source VS_{DEP}, and the optional bias switch SW_{DEP} is referred to as "bias node transistor arrangement" in the following. The bias node Q, which is coupled to the bias region 4 inside the semiconductor body 100 can be considered to be part of the superjunction transistor device so that the superjunction transistor device may also be referred to as bias node superjunction transistor device.

Figure 25 illustrates one example of an electronic circuit in which a bias node transistor arrangement 1 of the type explained is used as a rectifier element. In this example, the load path D-S of the superjunction transistor device TSJ included in the transistor arrangement 1 is connected in series with an electronic switch HS so that a half-bridge HB is formed by the superjunction transistor device and the electronic switch HS. The superjunction transistor device is referred to as TSJ in the following. Any type of electronic switch, e.g. another transistor arrangement of the same type as transistor arrangement 1, can be used as the electronic switch HS. A series circuit including the electronic switch HS and the transistor arrangement 1 is connected between a first supply node and a second supply node, wherein a supply voltage or input voltage V_{IN} is available between these supply nodes. Further, an inductive load 400 (that is, a load that includes at least one inductor 401) is connected in parallel with the drain-source path D-S of the superjunction transistor device TSJ of the transistor arrangement 1. In this type of circuit arrangement, the electronic switch HS serves as an electronic switch that connects the load 400 to the supply voltage V_{IN} dependent on a drive signal S_{HS} received by the electronic switch HS. The transistor arrangement 1 acts as a rectifier element (or freewheeling element) that takes over a current from the inductive load 400 when the switch HS switches off. In the half-bridge illustrated in Figure 25, the electronic switch HS forms a high-side switch and the bias node transistor arrangement 1 forms a low-side switch LS.

The transistor arrangement 1 may be operated as a passive rectifier element, so that the superjunction transistor device TSJ only changes between the diode state and the blocking state. The superjunction transistor device TSJ changes to the diode state when the electronic switch HS switches off and the inductive load 400 reverse biases the superjunction transistor device of the transistor arrangement 1. When the electronic switch HS again switches on, the electronic switch HS takes over the load current I_{L} and the superjunction transistor device TSJ changes to the blocking state. Operating the transistor arrangement 1 in this way is explained below with reference to Figure 26.

Figure 26 shows signal diagrams that illustrate one example of operating the electronic circuit shown in Figure 25. More specifically, Figure 26 shows signal waveforms of the drain-source voltage V_{DS}, the gate-source voltage V_{GS}, a control signal S_{HS} of the switch HS connected in series with the transistor arrangement 1, and a control signal S_{DEP} of the bias switch SW_{DEP} connected in series with the bias voltage source VS_{DEP}. Each of the control signals S_{HS}, S_{DEP} can have an on-level that switches on the respective switch HS, SW_{DEP}, or an off-level that switches off the respective switch HS, SW_{DEP}. Just for the purpose of illustration, the on-level is a logic high signal level and the off-level is a logic low signal level in this example.

In the example illustrated in Figure 26, the transistor arrangement 1 is operated such that the gate-source voltage V_{GS} of the superjunction transistor device TSJ is always below the threshold voltage so that the superjunction transistor device TSJ either operates in the diode state (the third operating state) or the blocking state (the fourth operating state). Just for the purpose of explanation it is assumed that the gate-source voltage V_{GS} is zero in this example. In this case, the operating state of the superjunction transistor device TSJ is only governed by the switch HS.

Referring to Figure 26, the switch HS connected in series with the transistor arrangement 1 is switched on before a first time instance 11. Thus, a voltage across the load 400, which equals the drain-source voltage V_{DS} of the transistor arrangement 1, essentially equals the supply voltage V_{IN} and the superjunction transistor device TSJ of the transistor arrangement 1 is in the blocking state. When the switch HS is in the on-state, a load current I_{L} flows through the inductive load 400 as indicated in Figure 25.

When the switch HS switches off at the first time instance 11, a commutation process starts, In this commutation process, the inductive load 400 forces the load current I_{L} to flow through the transistor arrangement 1, that is, the inductive load 400 reverse biases the superjunction transistor device TSJ and operates the superjunction transistor device TSJ in the diode state. Referring to Figure 26, the superjunction transistor device is not immediately reverse biased at the first time instance 11, but there is a transient phase between the first time instance t1 and a time instance t11 after the first time instance. In the transient phase, the operating state of the superjunction transistor device changes from the blocking state (fourth operating state) to the diode state (third operating state). During this transient phase, the drain-source voltage V_{DS} changes its polarity. Referring to Figure 26, when the electronic switch HS again switches on at a second time instance t2 (which is after the first time instance 11), the superjunction transistor device TSJ becomes forward biased and enters the blocking state so that the drain-source voltage V_{DS} again increases to a voltage level that essentially equals the supply voltage level V_{SUP}. More specifically, there is a transient phase between the second time instance t2 and a time instance t21 after the second time instance t2. In this transient phase, the superjunction transistor device TSJ changes from the diode state (third operating state) to the blocking state (fourth operating state). During this transient phase, the drain-source voltage V_{DS} again changes its polarity.

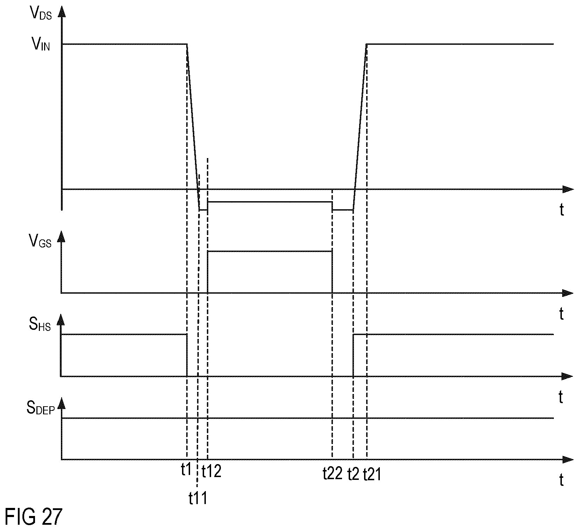

Figure 27 illustrates a modification of the drive scheme illustrated in Figure 26. In the example illustrated in Figure 27, the superjunction transistor device TSJ is operated in the reverse conducting state (the second operating state) after switching off the switch HS at the first time instance t1 and before again switching on the switch HS at the second time instance t2. More specifically, there is a first dead time between the first time instance t1 and a time instance t12 when the superjunction transistor device is switched on in order to operate in the reverse conducting state, wherein this dead time may be longer than the transient phase between t1 and t1 1 explained above. Further, there is a dead time between a time instance t22 at which the superjunction transistor device is switched off and the second time instance t2 at which the switch HS again switches on. During these dead times, the superjunction transistor device operates in the diode state including the above referenced transient phases. Referring to Figure 27, a magnitude of the drain-source voltage V_{DS} may be lower in the reverse conducting state than in the diode state. Thus, operating the superjunction transistor device in the reverse conducting state may help to reduce conduction losses when the superjunction transistor device conducts the load current I_{L}.

In each of the operating scenarios illustrated in Figures 26 and 27 there are transient phases in which the superjunction transistor device TSJ of the transistor arrangement 1 changes from the diode state to the blocking state. By applying the bias voltage V_{DEP} between the compensation regions 21 of the transistor cells 10 (not shown in Figure 25) and the bias regions 4 (also not shown in Figure 25) at least during the transient phase between the diode state and the blocking state losses associated with this transition can be reduced as explained in the following.

For explanation purposes it is assumed that the bias voltage source VS_{DEP} and the bias switch SW_{DEP} are omitted or that the bias switch SW_{DEP} is permanently open. In this case, the transistor arrangement 1 operates like a conventional transistor. Thus, when the transistor device changes from the diode state to the blocking state the current associated with this transition (that is, the current associated with removing the charge carrier plasma and forming the depletion region) is not absorbed by the depletion voltage source, but flows through a current path that includes the load paths of the transistor device and the electronic switch SW. The voltage across this current path equals the supply voltage V_{SUP}. This supply voltage V_{SUP} is selected dependent on the requirements of the load 400 and may be several hundred volts such as between 400V and 1000V. According to one example, the supply voltage is between 50% and 90% of the voltage blocking capabilities of the devices SW, 1 in the half-bridge.

The bias voltage V_{DEP} can be adjusted independent of the requirements of the load 400 and, as explained above, can be as low as several volts. Thus removing the charge carrier plasma and forming the depletion region governed by the bias voltage V_{DEP} results in much lower losses than removing the charge carrier plasma and forming the depletion region governed by the supply voltage V_{SUP}. Thus, using a transistor arrangement 1 explained above instead of a conventional superjunction transistor may help to significantly reduce commutation losses.

Referring to the above, the bias voltage V_{DEP} between the bias node Q and the drift region 11 removes charge carriers from the charge carrier plasma and causes the junction capacitances to be charged (that is, causes a depletion region to expand in the drift region 11 and the compensation region 21). The junction capacitance may further be charged as the load path voltage V_{DS} increases to voltage levels higher than the bias voltage V_{DEP}. The current associated with this further charging of the junction capacitance does not flow with the bias node Q but flows via the drain and source nodes D, S of the superjunction transistor device so that the losses associated with this current are essentially given by the current level multiplied with the supply voltage V_{SUP}, which may be significantly higher than the bias voltage V_{DEP}. In a superjunction transistor device, however, a capacitance value of the junction capacitance is not linearly on the voltage and significantly decreases as the voltage increases. In an modern superjunction transistor device with a voltage blocking capability of 800V such as Infineon's IPD80R900P7, for example, the capacitance decreases by about two orders of magnitude as the voltage across the junction capacitance increases between about 20V and about 30V. Thus, using the bias voltage V_{DEP} the junction capacitance can be pre-charged to a significant extent causing significant lower losses than charging the junction capacitance via the load path as usual.

Applying the bias voltage V_{DEP} between the bias region 4 and the compensation region 21 when the superjunction transistor TSJ is not in a transient phase between the diode state and the blocking state may cause losses. Thus, according to one example the bias voltage V_{DEP} is only applied for a rather short time that covers the transient phase. According to one example, applying the bias voltage V_{DEP} starts when the switch HS switches off, or several nanoseconds before the switch HS switches off, and ends when the drain-source voltage V_{DS} of the superjunction transistor TSJ has reached a predefined threshold.

In the examples explained before, the compensation region 21 is directly connected to the source node S. Thus, when the transistor device is in the reverse conducting state or the diode state and the bias voltage source VS_{DEP} is connected between the bias region 4 and the compensation region 21, the current between the drain node D and the source node S partially flows via the bias voltage source VS_{DEP}. The bias voltage source VS_{DEP}, therefore, has to be adapted to carry the load current in this example.

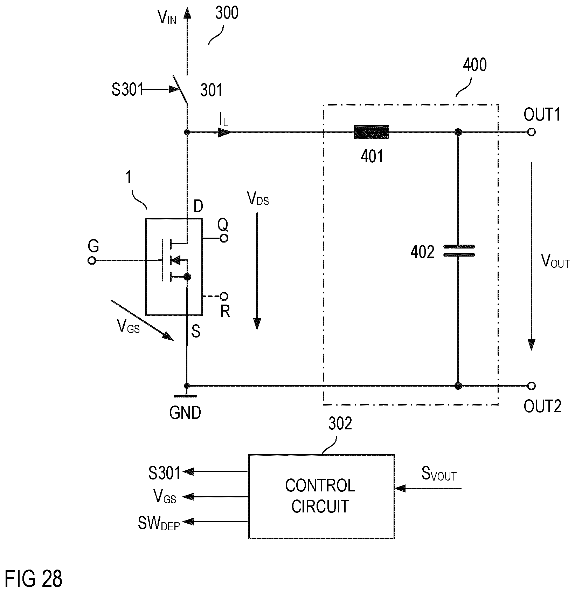

Figure 28 illustrates an electronic circuit with a half-bridge HB of the type explained with reference to Figure 25, wherein the electronic circuit shown in Figure 28 is implemented as a voltage converter (power converter). More specifically, the electronic circuit shown in Figure 28 is implemented as a buck converter. In this example, the load circuit 400 coupled to the half-bridge HB includes a series circuit with an inductor 401 and an output capacitor 402, wherein this series circuit is connected in parallel with the low-side switch LS of the half-bridge HB. The low-side switch LS of the half-bridge is implemented as a bias node transistor arrangement. For the sake of simplicity, the bias voltage source VS_{DP} and the bias switch SW_{DP} of the bias node transistor arrangement are not illustrated in Figure 28.

The buck converter shown in Figure 28 is configured to provide an output voltage V_{OUT} between output nodes OUT1, OUT2, wherein the output voltage V_{OUT} is a voltage across the output capacitor 402. The output voltage V_{OUT} is generated based on the input voltage V_{IN} that is received by the half-bridge HB. The output voltage V_{OUT} may be regulated by a control circuit 302 that generates pulse-width modulated (PWM) drive signals S301,V_{GS} received by the high-side switch HS and the low-side switch LS, respectively. The control circuit 302 receives an output voltage signal S_{VOUT} that represents the output voltage V_{OUT} and adjusts a duty cycle of operating the high-side switch HS and the low-side switch LS of the half-bridge HB in such a way that the output voltage V_{OUT} has a predefined voltage level. This is commonly known, so that no further explanation is required in this regard.

In addition to providing the drive signals S_{HS}, V_{GS} received by the high-side switch HS and the low-side switch LS the control circuit 302 may generate the drive signal S_{DEP} received by the bias switch SW_{DEP} (not shown in Figure 28), so that the control circuit 302 may be configured to operate the bias node transistor arrangement 1 in accordance with one of the examples explained with reference to Figures 26 and 27.

In the buck converter shown in Figure 28, the high-side switch HS is drawn as an electronic switch. This electronic switch may be implemented as any type of conventional electronic switch. According to another example, the high-side switch HS is implemented using a bias node transistor arrangement of the type explained herein above.

A half-bridge HB in which at least one of the high-side switch HS and the low-side switch LS is implemented as a bias node transistor arrangement 1 is, of course, not restricted to be used in a buck converter, but may be used in any kind of voltage converter (power converter) that includes at least one half-bridge, in particular a hard switching half-bridge. Further examples of power converters or inverters that include at least one half-bridge of the type explained with reference to Figures 25 and 27 are explained in the following.

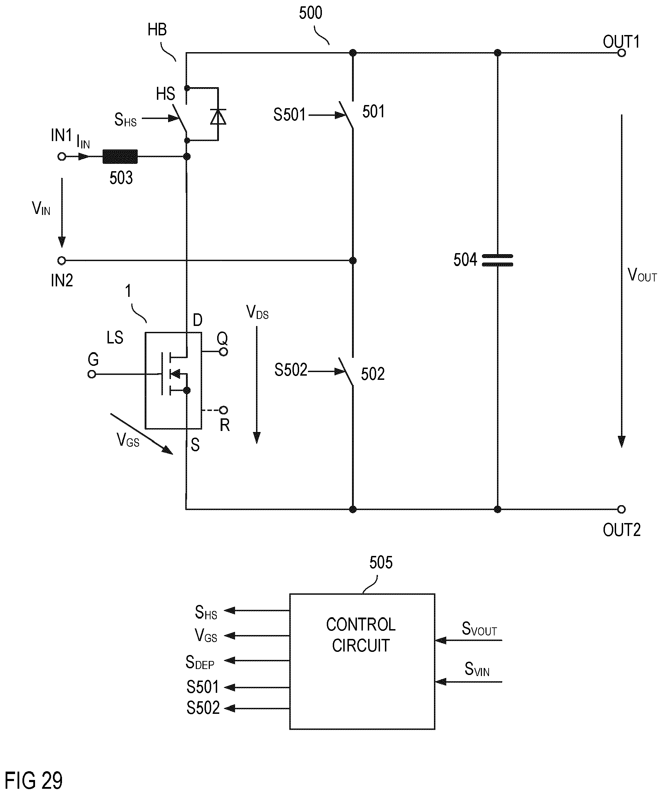

Figure 29 shows one example of a voltage converter with a totem-pole topology. This power converter includes a half-bridge HB of the type explained with reference to Figures 25 and 27 as a first half-bridge and a second half-bridge 500 with a high-side switch 501 and a low-side switch 502. A tap of the first half-bridge HB is coupled to a first input node IN1 via an inductor 503, and a tap of the second half-bridge 500 is connected to a second input node IN2, wherein an input voltage V_{IN} is available between the first input node IN1 and the second input node IN2. An output voltage V_{OUT} is available at an output capacitor 504, which is connected in parallel with the first half-bridge HB and the second half-bridge 500. A control circuit 505 drives the high-side switches and the low-side switches of the first half-bridge HB and the second half-bridge 500 by generating suitable drive signals S_{HS}, V_{GS}, S501, S502. The control circuit 505 receives an output voltage signal S_{VOUT} that represents the output voltage V_{OUT} and is configured to operate the half-bridges HB500 in such a way that the output voltage V_{OUT} has predefined voltage level.

The input voltage V_{IN} received by the voltage converter shown in Figure 29 may be an alternating input voltage, such as a sinusoidal input voltage V_{IN}. In this case, the control circuit 505 may further be configured to operate the half-bridges HB500 in such a way that an average of an input current I_{IN} received at the input IN1, IN2 is essentially proportional to the input voltage V_{IN}. A power converter of this type is usually referred to as PFC (Power Factor Correction) converter. For regulating the input current I_{IN} the control circuit 505 may receive an input current signal S_{IIN} that represents the input current I_{IN} and an input voltage signal S_{VIN} that represents the input voltage V_{IN}. The function of a PFC converter with a totem-pole topology is commonly known, so that no further explanation is required with regard to the functionality of the control circuit 505 shown in Figure 29.

In the power converter shown in Figure 29, the high-side switch 501 and the low-side switch 502 of the second half-bridge 500 may be implemented using conventional electronic switches such as MOSFETs or IGBTs, for example. These switches 501, 502 are operated with a relatively low-switching frequency. According to one example, the low-side switch 501 is switched on and the high-side switch is switched off throughout positive half-waves of the input voltage V_{IN}, and the high-side switch 501 is switched on and the low-side switch is switched off throughout negative half-waves of the input voltage V_{IN}. The switching frequency of these switches therefore equals twice the frequency of the alternating input voltage.

The high-side switch HS and the low-side switch LS of the first half-bridge HB, however, are switched at a higher switching frequency, such as a switching frequency in the range of several kHz. The high-side switch and the low side switch HS, LS are switched on and off complementarily so that only one these switches is switched on at the same time.

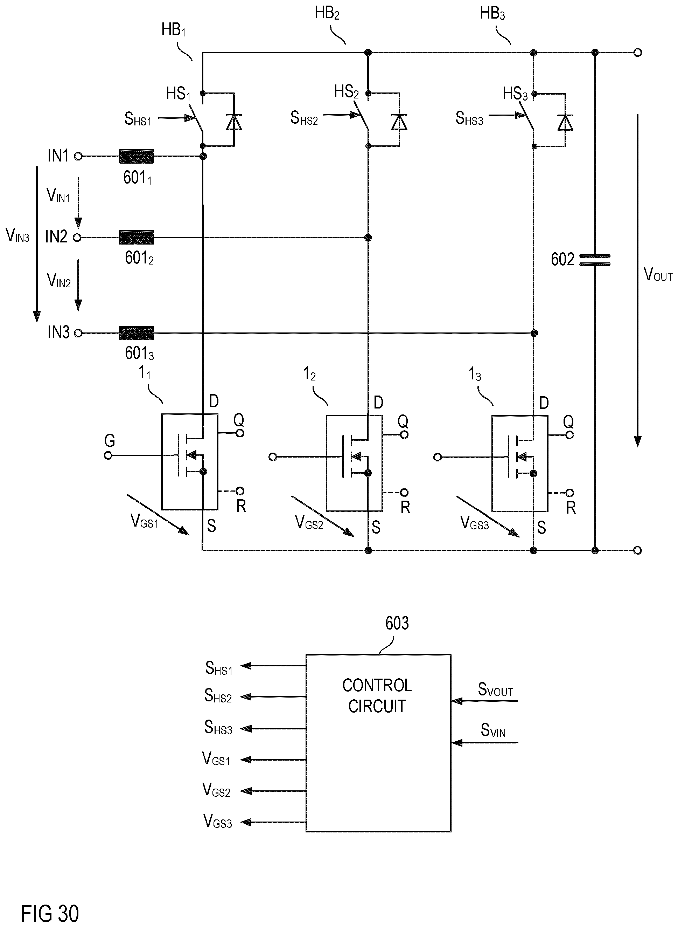

Figure 30 illustrates a power converter with a so called B6-topology. This power converter includes three half-bridges HB₁, HB₂, HB₃ of the type explained with reference to Figures 25 and 27. Each of these half-bridges HB₁, HB₂, HB₃ includes a tap that is coupled to a respective input node IN1, IN2, IN3 via a respective inductor 601₁, 601₂, 601₃. This power converter receives three input voltages V_{IN1}, V_{IN2}, V_{IN3}, wherein each of these input voltages V_{IN1}, V_{IN2}, V_{IN3} is received between a respective pair of the three input nodes IN1, IN2, IN3. An output voltage V_{OUT} is available at an output capacitor 602, which is connected in parallel with the three half-bridges HB₁, HB₂, HB₃. A control circuit 603 controls operation of the high-side switches HS₁, HS₂, HS₃ and the low-side switches LS₁, LS₂, LS₃ of the half-bridges HB₁, HB₂, HB₃. According to one example, the control circuit 603 is configured to control operation of the half-bridges HB₁-HB₃ in such a way that the output voltage V_{OUT} has a predefined voltage level. A voltage converter of the type shown in Figure 30 may be used to generate an output voltage V_{OUT} based on three alternating input voltages V_{IN1}-V_{IN3}, wherein these input voltages V_{IN1}-V_{IN3} may be sinusoidal input voltages and wherein a phase shift between these input voltages may be 60°, for example. However, a converter of the type shown in Figure 30 may also be used to receive an input voltage at the capacitor 602 and provide phase shifted alternating voltages at the circuit nodes IN1, IN2, IN3 to drive a motor, for example.

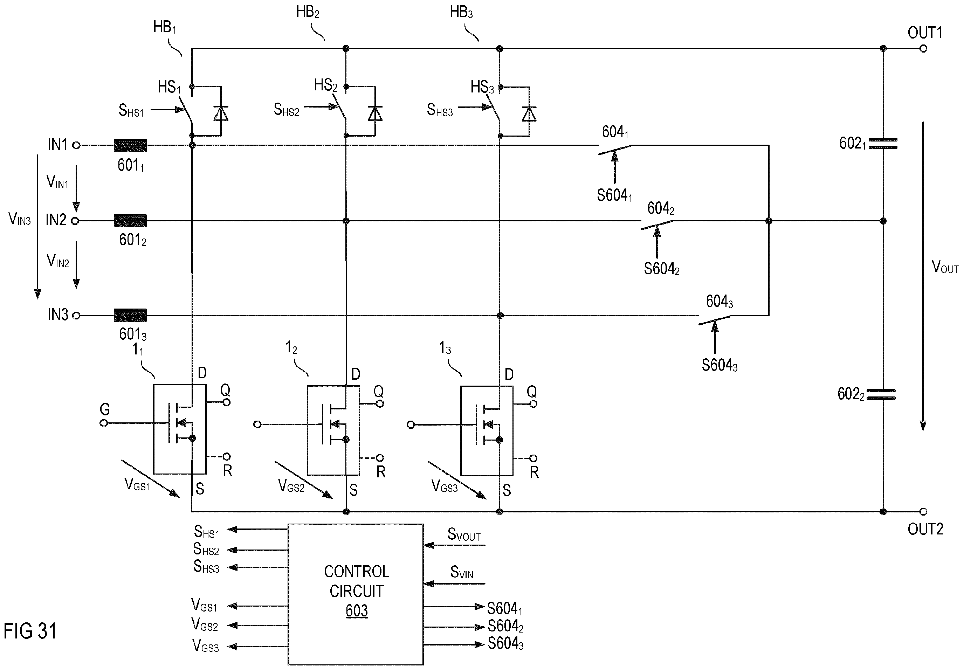

Figure 31 shows a modification of the power converter shown in Figure 30. In the power converter shown in Figure 31 the output voltage V_{OUT} is available across a series circuit with two capacitors 602₁-602₂. A tap of the capacitor series circuit is connected to the tap of each of the half-bridges HB₁-HB₃ via a respective electronic switch 604₁, 604₂, 604₃. These electronic switches 604₁-604₃ are bidirectionally blocking electronic switches, for example. A power converter of the type shown in Figure 31 is usually referred to as T-type inverter. This type of inverter may be used to generate an output voltage V_{OUT} based on alternating input voltages V_{IN1}-V_{IN3} received at the input IN1-IN3. Alternatively, this type of inverter may be used to drive a motor based on a voltage received across the capacitor series circuit. A control circuit 603 is configured to drive the half-bridges HB₁-HB₃ and the switches 604₁-604₃ between the taps of the half-bridges HB₁-HB₃ and the tap of the capacitor series circuit.

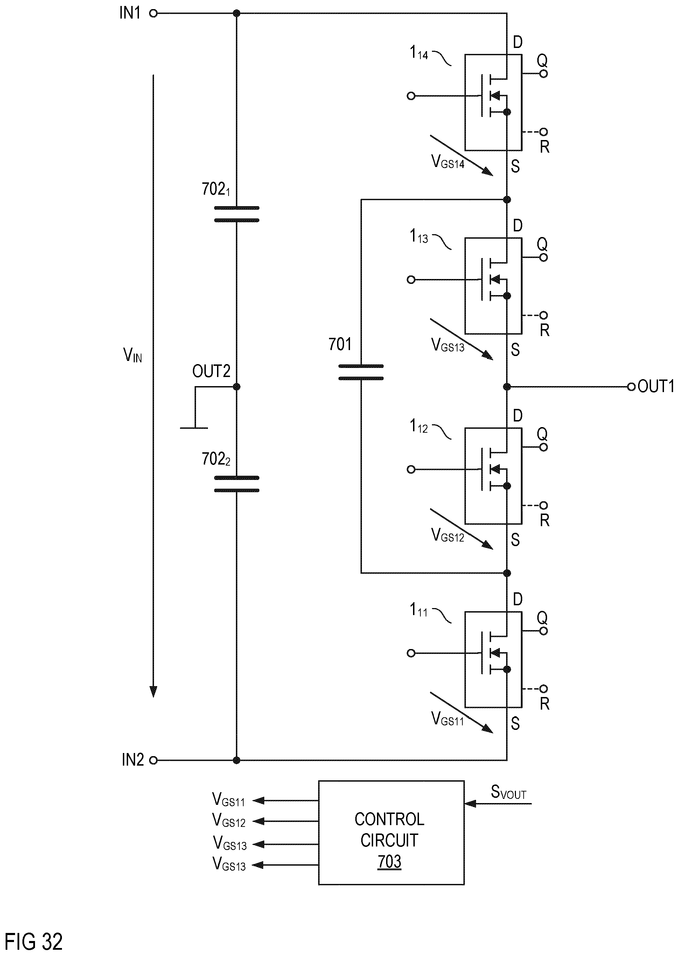

Figure 32 illustrates an example of a power converter according to another example. This power converter is implemented as a flying capacitor converter and includes a series circuit with a plurality of switches 1₁₁, 1₁₂, 1₁₃, 1₁₄, wherein each of these switches may be implemented as a bias node transistor arrangement. This power converter receives an input voltage V_{IN} between input nodes IN1, IN2, wherein a series circuit including the individual switches 1₁₁-1₁₄ is connected between the input nodes IN1, IN2. An output voltage is available between a first output node OUT1 and a second output node OUT2. The first output node OUT1 is formed by a tap of the series circuit including the individual switches 1₁₁-1₁₄, and the second output node OUT2 is formed by a tap of a capacitor series circuit 702₁, 702₂ connected between the input nodes IN1, IN2. A further capacitor (flying capacitor) 701 is connected between further taps of the switch series circuit 1₁₁-1₁₄. A control circuit 703 controls operation of the individual switches in order to provide a regulated output voltage. This is commonly known, so that no further explanation is required in this regard.

It goes without saying that the topology shown in Figure 32 is only one of a plurality of different examples of a flying capacitor converter. In any kind of flying capacitor the one or more of the individual switches may be implemented using a bias node transistor arrangement of the type explained herein above.

## Claims

1. A transistor arrangement, comprising:
in a semiconductor body (100), a drift region (11) of a first doping type, a compensation region (21) of a second doping type complementary to the first doping type, a body region (22) of the second doping type, and a source region (12) of the first doping type;
a gate electrode (31), wherein the gate electrode (31) is coupled to a gate node (G), is dielectrically insulated from the semiconductor body (100) and is arranged in a gate trench that extends into the semiconductor body (100) and adjoins the compensation region (21);
a first field electrode (55i), wherein the first field electrode (55₁) is dielectrically insulated from the semiconductor body (100) and is arranged in a first isolation trench (51) that extends into the semiconductor body (100), wherein the first isolation trench is spaced apart from the gate trench and adjoins the compensation region (21); and
a bias node (Q) different from the gate node (G) and connected to the first field electrode (55i).

2. The transistor arrangement according to claim 1, further comprising:
a bias voltage source (VS_{DEP}) configured to provide a bias voltage (V_{DEP}) and coupled between the bias node (Q) and at least one of the compensation region (21) and the body region (22).

3. The transistor arrangement of claim 2, wherein the bias voltage source (VS_{DEP}) is coupled to the field electrode (55₁) via a bias switch (SW_{DEP}).

4. The transistor arrangement of claim 1, further comprising:
a resistor (R) connected between the gate node (G) and the bias node (Q).

5. The transistor arrangement of claim 4, wherein a resistance of the resistor (R) is between 1.2 times and 100 times a gate resistance between the gate node (G) and the gate electrode (31).

6. The transistor arrangement of claim 4 or 5, wherein the resistor (R) is integrated in the semiconductor body (100).

7. The transistor arrangement of any one of the preceding claims, further comprising:
a second field electrode (33) arranged in the gate trench below the gate electrode (31) and dielectrically insulated from the semiconductor body (100).

8. The transistor arrangement of claim 7, wherein the second field electrode (33) is connected to the gate node (G).

9. The transistor arrangement of any one of the preceding claims, further comprising:
a bias region (4) arranged in the semiconductor body (100) and coupled to the bias node (Q).

10. The transistor arrangement of claim 9, wherein the bias region (4) adjoins the first isolation trench (51).

11. The transistor arrangement of claim 10, further comprising:
a second isolation trench (52) spaced apart from the first isolation trench (51),
wherein the bias region (4) is arranged between the first isolation trench (51) and the second isolation trench (52).

12. The transistor arrangement of any one of claims 9 to 11,
wherein the bias region (4) is of the first doping type.

13. The transistor arrangement of any one of claims 9 to 11,
wherein the bias region (4) is of the second doping type.

14. The transistor arrangement of claim 1, wherein the gate node (G) is connected to the first field electrode (55i) via a resistor (R).

15. The transistor arrangement of claim 14, wherein a resistance of the resistor (R) is between 1.2 times and 100 times a gate resistance between the gate node (G) and the gate electrode (31).

## Patentansprüche

1. Transistoranordnung, die aufweist:
in einem Halbleiterkörper (100), ein Driftgebiet (11) eines ersten Dotierungstyps, ein Kompensationsgebiet (21) eines zu dem ersten Dotierungstyp komplementären zweiten Dotierungstyps, ein Bodygebiet (22) des zweiten Dotierungstyps und ein Sourcegebiet (12) des ersten Dotierungstyps;
eine Gateelektrode (31), wobei die Gateelektrode (31) an einen Gateknoten (G) gekoppelt ist, dielektrisch von dem Halbleiterkörper (100) isoliert ist und in einem Gategraben angeordnet ist, der sich in den Halbleiterkörper (100) erstreckt und an das Kompensationsgebiet (21) angrenzt;
eine erste Feldelektrode (55₁), wobei die erste Feldelektrode (55₁) dielektrisch von dem Halbleiterkörper (100) isoliert ist und in einem ersten Isolationsgraben (51) angeordnet ist, der sich in den Halbleiterkörper (100) erstreckt, wobei der erste Isolationsgraben zu dem Gategraben beabstandet ist und an das Kompensationsgebiet (21) angrenzt; und
einen Vorspannungsknoten (Q), der sich von dem Gateknoten (G) unterscheidet und an die erste Feldelektrode (55₁) angeschlossen ist.

2. Transistoranordnung nach Anspruch 1, die weiterhin aufweist:
eine Vorspannungsquelle (VS_{DEP}), die dazu ausgebildet ist, eine Vorspannung (V_{DEP}) bereitzustellen und die zwischen den Vorspannungsknoten (Q) und wenigstens eines von dem Kompensationsgebiet (21) und dem Bodygebiet (22) gekoppelt ist.

3. Transistoranordnung nach Anspruch 2, wobei die Vorspannungsquelle (VS_{DEP}) über einen Vorspannungsschalter (SW_{DEP}) an die Feldelektrode (55₁) gekoppelt ist.

4. Transistoranordnung nach Anspruch 1, die weiterhin aufweist:
einen Widerstand (R), der zwischen den Gateknoten (G) und den Vorspannungsknoten (Q) gekoppelt ist.

5. Transistoranordnung nach Anspruch 4, wobei ein Widerstandswert des Widerstands (R) zwischen dem 1,2-fachen und dem 100-fachen eines Gate-Widerstandswerts zwischen dem Gateknoten (G) und der Gateelektrode (31) beträgt.

6. Transistoranordnung nach Anspruch 4 oder 5, wobei der Widerstand (R) in dem Halbleiterkörper (100) integriert ist.

7. Transistoranordnung nach einem beliebigen der vorangehenden Ansprüche, die weiterhin aufweist:
eine zweite Feldelektrode (33), die in dem Gategraben unter der Gateelektrode (31) angeordnet ist und dielektrisch von dem Halbleiterkörper 100) isoliert ist.

8. Transistoranordnung nach Anspruch 7, wobei die zweite Feldelektrode (33) an den Gateknoten (G) angeschlossen ist.

9. Transistoranordnung nach einem beliebigen der vorangehenden Ansprüche, die weiterhin aufweist:
ein Vorspannungsgebiet (4), dass in dem Halbleiterkörper (100) angeordnet ist und an den Vorspannungsknoten (Q) gekoppelt ist

10. Transistoranordnung nach Anspruch 9, wobei das Vorspannungsgebiet (4) an den ersten Isolationsgraben (51) angrenzt.

11. Transistoranordnung nach Anspruch 10, die weiterhin aufweist:
einen zweiten Isolationsgraben (52), der zu dem ersten Isolationsgraben (51) beabstandet ist,
wobei das Vorspannungsgebiet (4) zwischen dem ersten Isolationsgraben (51) und dem zweiten Isolationsgraben (52) angeordnet ist.

12. Transistoranordnung nach einem beliebigen der Ansprüche 9 bis 11,
wobei das Vorspannungsgebiet (4) vom ersten Dotierungstyps ist.

13. Transistoranordnung nach einem beliebigen der Ansprüche 9 bis 11,
wobei das Vorspannungsgebiet (4) vom zweiten Dotierungstyps ist.

14. Transistoranordnung nach Anspruch 1, wobei der Gateknoten (G) an die erste Feldelektrode (55₁) über einen Widerstand (R), zu angeschlossen ist.

15. Transistoranordnung nach Anspruch 14, wobei ein Widerstandswert des Widerstands (R) zwischen dem 1,2-fachen und dem 100-fachen eines Gate-Widerstandswerts zwischen dem Gateknoten (G) und der Gateelektrode (31) beträgt.

## Revendications

1. Dispositif de transistor, comprenant :
dans un corps (100) semiconducteur, une région (11) de migration d'un premier type de dopage, une région (21) de compensation d'un second type de dopage complémentaire du premier type de dopage, une région (22) de corps du second type de dopage, et une région (12) de source du premier type de dopage ;
une électrode (31) de grille, dans lequel l'électrode (31) de grille est reliée à un noeud (G) de grille, est isolée diélectriquement du corps (100) semiconducteur et est disposée dans une tranchée de grille, qui s'étend dans le corps (100) semiconducteur et qui est contigüe à la région (21) de compensation ;
une première électrode (55₁) de champ, dans lequel la première électrode (55₁) de champ est isolée diélectriquement du corps (100) semiconducteur et est disposée dans une première tranchée (51) d'isolement, qui s'étend dans le corps (100) semiconducteur, dans lequel la première tranchée d'isolement est à distance de la tranchée de grille et est contigüe de la région (21) de compensation ; et
un noeud (Q) de polarisation différent du noeud (G) de grille et connecté à la première électrode (55₁) de champ.

2. Dispositif de transistor suivant la revendication 1, comprenant en outre :
une source (VS_{DEP}) de tension de polarisation configurée pour donner une tension (V_{DEP}) de polarisation et montée entre le noeud (Q) de polarisation et au moins l'une de la région (21) de compensation et de la région (22) de corps.

3. Dispositif de transistor suivant la revendication 2, dans lequel la source (VS_{DEP}) de tension de polarisation est reliée à l'électrode (55₁) de champ par un interrupteur (SW_{DEP}) de polarisation.

4. Dispositif de transistor suivant la revendication 1, comprenant en outre :
une résistance (R) montée entre le noeud (G) de grille et le noeud (Q) de polarisation.

5. Dispositif de transistor suivant la revendication 4, dans lequel une valeur de la résistance (R) représente entre 1,2 fois et 100 fois une résistance de grille entre le noeud (G) de grille et l'électrode (31) de grille.

6. Dispositif de transistor suivant la revendication 4 ou 5, dans lequel la résistance (R) est intégrée dans le corps (100) semiconducteur.

7. Dispositif de transistor suivant l'une quelconque des revendications précédentes, comprenant en outre :
une deuxième électrode (33) de champ disposée dans la tranchée de grille en-dessous de l'électrode (31) de grille et isolée diélectriquement du corps (100) semiconducteur.

8. Dispositif de transistor suivant la revendication 7, dans lequel la deuxième électrode (33) de champ est disposée au noeud (G) de grille.

9. Dispositif de transistor suivant l'une quelconque des revendications précédentes, comprenant en outre :
une région (4) de polarisation disposée dans le corps (100) semiconducteur et reliée au noeud (Q) de polarisation.

10. Dispositif de transistor suivant la revendication 9, dans lequel la région (4) de polarisation est contigüe de la première tranchée (51) d'isolement.

11. Dispositif de transistor suivant la revendication 10, comprenant en outre :
une deuxième tranchée (52) d'isolement à distance de la première tranchée (51) d'isolement,
dans lequel la région (4) de polarisation est montée entre la première tranchée (51) d'isolement et la deuxième tranchée (52) d'isolement.

12. Dispositif de transistor suivant l'une quelconque des revendications 9 à 11,
dans lequel la région (4) de polarisation est du premier type de dopage.

13. Dispositif de transistor suivant l'une quelconque des revendications 9 à 11,
dans lequel la région (4) de polarisation est du second type de dopage.

14. Dispositif de transistor suivant la revendication 1, dans lequel le noeud (G) de grille est connecté à la première électrode (55₁) de champ par une résistance (R).

15. Dispositif de transistor suivant la revendication 14, dans lequel une valeur de la résistance (R) représente entre 1,2 fois et 100 fois une résistance de grille entre le noeud (G) de grille et l'électrode (31) de grille.
